# EUROPEAN PATENT SPECIFICATION

(11) **EP 4 354 502 B1**
(45) Date of publication and mention of the grant of the patent: **17.12.2025**
(21) Application number: 23735955.9
(22) Date of filing: 19.06.2023
(51) Int. Cl.: H04M 1/02, H05K 9/00, G09G 5/00

(54) **DISPLAY AND ELECTRONIC DEVICE COMPRISING SAME**
ANZEIGE UND ELEKTRONISCHE VORRICHTUNG DAMIT
ÉCRAN ET DISPOSITIF ÉLECTRONIQUE LE COMPRENANT

(30) Priority: 31.08.2022 KR 20220109867; 20.09.2022 KR 20220118405
(43) Date of publication of application: 17.04.2024
(73) Proprietor: Samsung Electronics Co., Ltd., Suwon-si, Gyeonggi-do 16677 (KR)
(72) Inventor: CHO, Kyonghwan, Suwon-si, Gyeonggi-do 16677 (KR); KIM, Jongmin, Suwon-si, Gyeonggi-do 16677 (KR); KWON, Eunbae, Suwon-si, Gyeonggi-do 16677 (KR); HONG, Sangho, Suwon-si, Gyeonggi-do 16677 (KR)
(74) Representative: Gulde & Partner
(86) International application number: PCT/KR2023/008420
(87) International publication number: WO 2024/048931

(56) References cited:
- KR-A- 20130 088 102
- KR-A- 20200 061 445
- KR-A- 20200 073 349
- KR-A- 20200 129 224
- US-A1- 2015 201 535
- US-A1- 2017 250 460
- US-A1- 2021 105 890

## Description

### [Technical Field]

One or more embodiments of the disclosure relate to an electronic device, for example, a display and/or an electronic device including the same.

### [Background Art]

With the development of electronic, information, or communication technology, various functions are included in a single electronic device. For example, a smartphone may include functions of a sound playback device, an imaging device, or a digital diary, in addition to a communication function, and more various functions may be implemented in a smartphone through installation of additional applications. An electronic device may be provided with various pieces of information in real time by accessing a server or another electronic device in a wired or wireless manner as well as by executing an installed application or a stored file.

As the performance of electronic devices has been enhanced and the electronic devices have been downsized, and it has become possible for users to carry and use electronic devices on a daily basis. The development of information and communication technology makes it convenient to carry and use electronic devices by increasing the degree of integration of electronic devices. As the degree of integration of electronic devices increases, a stable operating environment may be provided inside electronic devices by suppressing mutual interference between components and protecting internal components from external causes (e.g., impacts caused by changes in temperature and humidity or dropping).

The above-described information may be provided as background for the purpose of helping understanding of the disclosure. No claim or determination is made as to whether any of the foregoing may be applied as a prior art in connection with the disclosure.

Conventional devices are known from US 2021/105890 A1.

### [Detailed Description of the Invention]

### [Technical Solution]

According to an embodiment of the disclosure, a display may include a display panel including a light-emitting layer, a flexible printed circuit board extending from the display panel and at least partially disposed on a rear surface of the display panel, a display driver integrated circuit ("DDI") disposed on one surface of the flexible printed circuit board and configured to drive the display panel, and a shield film attached to the flexible printed circuit board in a state of enclosing at least a portion of the DDI. In an embodiment, the flexible printed circuit board may include at least one through hole or at least one recess provided in an area where the shield film is attached, and wherein the at least one through hole or the at least one recess is configured to function as air discharge passage when the shield film is attached to the flexible printed circuit board.

According to an embodiment of the disclosure, an electronic device may include a housing including a first surface, a second surface facing a direction opposite to the first surface, and a side structure surrounding at least a portion of the space between the first surface and the second surface, a display disposed in the space at least partially surrounded by the side structure and configured to output a screen through at least a portion of the first surface, and a processor or a communication module configured to execute wireless communication by using at least a portion of the side structure (hereinafter, a "radiation conductor"). In an embodiment, the display may include a display panel including a light-emitting layer, a flexible printed circuit board extending from the display panel at a position adjacent to the radiation conductor and at least partially disposed on a rear surface of the display panel, a DDI disposed on one surface of the flexible printed circuit board and configured to drive the display panel; and a shield film attached to the flexible printed circuit board in a state of enclosing at least a portion of the DDI. In an embodiment, the flexible printed circuit board may include at least one through hole or at least one recess provided in an area where the shield film is attached, and wherein the at least one through hole or the at least one recess is configured to function as air discharge passage when the shield film is attached to the flexible printed circuit board.

### [Brief Description of Drawings]

The above-described aspects or other aspects, configurations, and/or advantages regarding an embodiment of the disclosure may become more apparent through the following detailed description made with reference to the accompanying drawings.
FIG. 1 is a block diagram illustrating an electronic device according to an embodiment of the disclosure within a network environment.
FIG. 2 is a front perspective view of an electronic device according to an embodiment of the disclosure.
FIG. 3 is a rear perspective view of the electronic device according to an embodiment of the disclosure illustrated in FIG. 2.
FIG. 4 is a front exploded perspective view illustrating the electronic device according to an embodiment illustrated in the disclosure of FIG. 2.
FIG. 5 is a rear exploded perspective view illustrating the electronic device according to an embodiment of the disclosure illustrated in FIG. 2.
FIG. 6 is an exploded perspective view illustrating a display of an electronic device according to an embodiment of the disclosure.
FIG. 7 is a view illustrating a shield film in a display of an electronic device according to an embodiment of the disclosure.
FIG. 8 is a view illustrating the shield film of FIG. 7 according to an embodiment of the disclosure.
FIG. 9 is a view illustrating the shield film according to an embodiment of the disclosure, cut along line A-A' in FIG. 7.
FIG. 10 is a perspective view illustrating a state in which a flexible printed circuit board is disposed on a display panel in a display of an electronic device according to an embodiment of the disclosure.
FIG. 11 is a perspective view illustrating a state in which a shield film is disposed on a flexible printed circuit board in a display of an electronic device according to an embodiment of the disclosure.
FIG. 12 is a view illustrating an arrangement of a side structure or a support member and a shield film in an electronic device according to an embodiment of the disclosure.
FIG. 13 is a view illustrating an arrangement of through holes or recesses in a display of an electronic device according to an embodiment of the disclosure.
FIG. 14 is a view for explaining an arrangement of a through hole or a recess in a display of an electronic device according to an embodiment of the disclosure.
FIG. 15 is a view illustrating an arrangement of through holes or slits in a display of an electronic device according to an embodiment of the disclosure.
FIG. 16 is a view for explaining an arrangement of a through hole or a slit in a display of an electronic device according to an embodiment of the disclosure.
FIG. 17 is a view illustrating an arrangement of slits in a display of an electronic device according to an embodiment of the disclosure.
FIG. 18 is a view for explaining an arrangement of a slit in a display of an electronic device according to an embodiment of the disclosure.
FIG. 19 is a view illustrating an arrangement of through holes or recesses in a display of an electronic device according to an embodiment of the disclosure.
FIG. 20 is a view for explaining an arrangement of a through hole or a recess in a display of an electronic device according to an embodiment of the disclosure.
FIG. 21 is a view illustrating an arrangement of through holes or slits in a display of an electronic device according to an embodiment of the disclosure.
FIG. 22 is a view for explaining an arrangement of a through hole or a slit in a display of an electronic device according to an embodiment of the disclosure.

Throughout the appended drawings, like reference numerals may be assigned to like parts, components, and/or structures.

### [Mode for Carrying out the Invention]

Due to the increase in the degree of integration of electronic devices and/or the down-sizing of electronics, the operating environment of various components inside the electronic devices may be poor. For example, as generation of electromagnetic waves increases in the operation of circuit devices such as various processors or communication modules, electronic interference may degrade the operating efficiency (e.g., power efficiency) of other circuit devices or cause malfunction. When multiple antennas corresponding to different communication protocols or antennas for transmitting/receiving wireless power are mounted in a downsized electronic device, a wireless communication environment may become worse. In an electronic device, electromagnetic interference between various components may be suppressed by disposing a structure or component for electromagnetic shielding between the various components. However, when a shield structure is disposed adjacent to an antenna, the radiation performance of the antenna may be degraded. A change in radiation performance of an antenna by a structure adjacent to the antenna may be caused due to a manufacturing tolerance or assembly tolerance of the structure. For example, there may be a deviation in antenna radiation performance in multiple different products manufactured with the same specification.

An embodiment of the disclosure is to solve at least the above-mentioned problems and/or disadvantages and to provide at least the following advantages, and is able to provide a shield structure capable of providing a stable wireless communication environment, a display including the same, and/or an electronic device including the display.

An embodiment of the disclosure may provide a display in which generation of a manufacturing tolerance or assembly is suppressed and/or an electronic device including the display.

The technical problems to be addressed by the disclosure are not limited to those described above, and other technical problems, which are not described above, may be clearly understood from the following description by a person ordinarily skilled in the related art, to which the disclosure belongs.

The following description made with reference to the appended drawings may provide an understanding of various exemplary implementations of the disclosure, including the claims. An exemplary embodiment disclosed in the following description includes various specific details to aid understanding, but is considered to be one of various exemplary embodiments. Accordingly, it will be understood those skilled in the art that the various implementations described herein may be variously changed and modified without departing from the scope of the disclosure. In addition, descriptions of well-known functions and configurations may be omitted for clarity and brevity.

The terms and words used in the following description and claims are not limited to a bibliographical meaning, but may be used to describe an embodiment of the disclosure clearly and consistently. Therefore, it will be obvious to those skilled in the art that the following description of various implementations of the disclosure is provided for the purpose of explanation, not for the purpose of limiting the disclosure defined as the scope of rights.

It is to be understood that the singular forms of "a", "an", and "the" contain the "plural" meaning as well, unless the context clearly indicates otherwise. Thus, for example, "a component surface" may be understood to include one or more of the surfaces of the component.

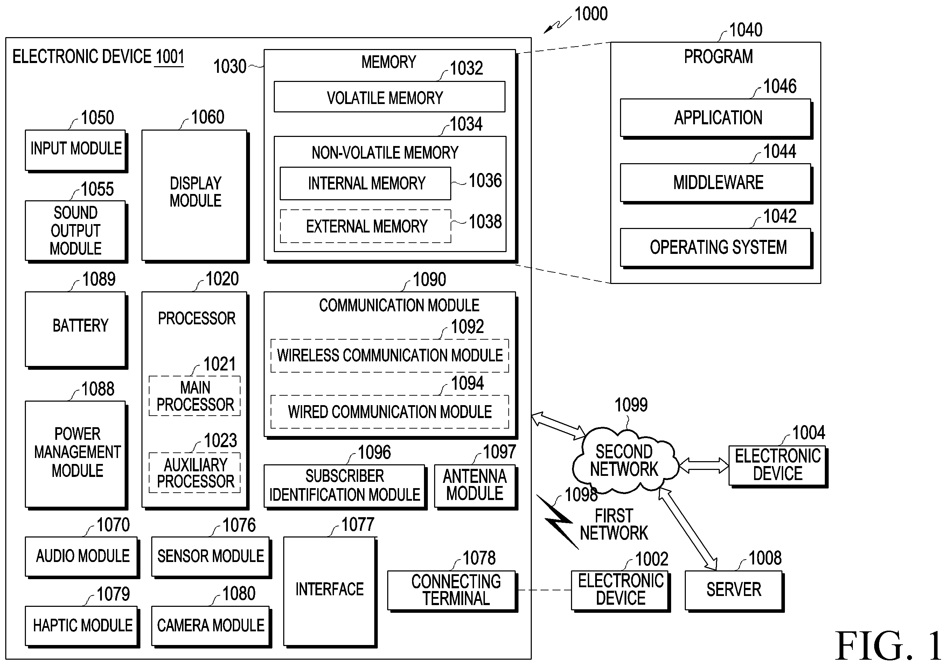

FIG. 1 is a block diagram illustrating an electronic device 1001 in a network environment 1000 according to various embodiments. Referring to FIG. 1, the electronic device 1001 in the network environment 1000 may communicate with an electronic device 1002 via a first network 1098 (e.g., a short-range wireless communication network), or at least one of an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In some embodiments, at least one of the components (e.g., the connecting terminal 1078) may be omitted from the electronic device 1001, or one or more other components may be added in the electronic device 1001. In some embodiments, some of the components (e.g., the sensor module 1076, the camera module 1080, or the antenna module 1097) may be implemented as a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 1021. For example, when the electronic device 1001 includes the main processor 1021 and the auxiliary processor 1023, the auxiliary processor 1023 may be adapted to consume less power than the main processor 1021, or to be specific to a specified function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023. According to an embodiment, the auxiliary processor 1023 (e.g., the neural processing unit) may include a hardware structure specified for artificial intelligence model processing. An artificial intelligence model may be generated by machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by another component (e.g., the processor 1020) of the electronic device 1001, from the outside (e.g., a user) of the electronic device 1001. The input module 1050 may include, for example, a microphone, a mouse, a keyboard, a key (e.g., a button), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display module 1060 may include, for example, a display, a hologram device, or a projector and control circuitry to control a corresponding one of the display, hologram device, and projector. According to an embodiment, the display module 1060 may include a touch sensor adapted to detect a touch, or a pressure sensor adapted to measure the intensity of force incurred by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., an electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. According to an embodiment, the sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or a movement) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as BluetoothTM, wireless-fidelity (Wi-Fi) direct, or infrared data association (IrDA)) or the second network 1099 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device) of the electronic device 1001. According to an embodiment, the antenna module 1097 may include an antenna including a radiating element composed of a conductive material or a conductive pattern formed in or on a substrate (e.g., a printed circuit board (PCB)). According to an embodiment, the antenna module 1097 may include a plurality of antennas (e.g., array antennas). In such a case, at least one antenna appropriate for a communication scheme used in the communication network, such as the first network 1098 or the second network 1099, may be selected, for example, by the communication module 1090 (e.g., the wireless communication module 1092) from the plurality of antennas. The signal or the power may then be transmitted or received between the communication module 1090 and the external electronic device via the selected at least one antenna. According to an embodiment, another component (e.g., a radio frequency integrated circuit (RFIC)) other than the radiating element may be additionally formed as part of the antenna module 1097.

According to various embodiments, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. Each of the electronic devices 1002 or 1004 may be a device of a same type as, or a different type, from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In another embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," ***"coupled to," "connected with,"*** or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

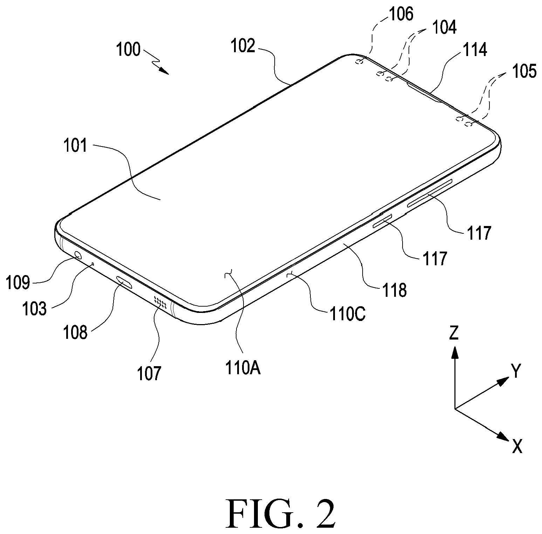

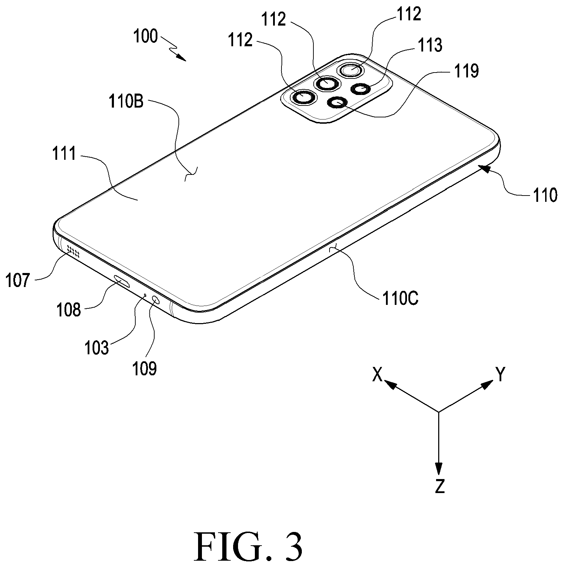

FIG. 2 is a front perspective view of an electronic device 100 according to an embodiment of the disclosure. FIG. 3 is a rear perspective view of the electronic device 100 of FIG. 2 according to an embodiment of the disclosure.

Referring to FIGS. 2 and 3, the electronic device 100 (e.g., the electronic device 1001 in FIG. 1) according to an embodiment may include a housing 110 including a first surface (or the front surface) 110A, a second surface (or the rear surface) 110B, and a side surface 110C surrounding the space between the first surface 110A and the second surface 110B. In an embodiment (not illustrated), the housing 110 may refer to a structure that defines some of the first surface 110A of FIG. 2, and the second surface 110B and the side surface 110C of FIG. 3. According to an embodiment, at least a portion of the first surface 110A may be defined by a substantially transparent front surface plate 102 (e.g., a glass plate or a polymer plate including various coating layers). The second surface 110B may be defined by a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. The side surface 110C may be defined by the side structure (or a "side bezel structure") 118 coupled to the front surface plate 102 and the rear surface plate 111 and including metal and/or polymer. In an embodiment, the rear surface plate 111 and the side structure 118 may be integrated with each other and may include the same material (e.g., a metal material such as aluminum).

Although not illustrated, the front surface plate 102 may include one or more areas that extend seamlessly from at least a portion of an edge toward the rear surface plate 111. In an embodiment, the front surface plate 102 (or the rear surface plate 111) may include only one of the areas bent and extending toward the rear surface plate 111 (or the front surface plate 102), at one side edge of the first surface 110A. According to an embodiment, the front surface plate 102 or the rear surface plate 111 may have a substantially flat plate shape, and in this case, may not include a bent and extending area. When the bent and extending area is included, the thickness of the electronic device 100 in the portion including the bent and extending area may be smaller than the thicknesses of other portions.

According to an embodiment, the electronic device 100 may include at least one of a display 101, an audio module (e.g., a microphone hole 103, an external speaker hole 107, and a call receiver hole 114), a sensor module (e.g., a first sensor module 104, a second sensor module (not illustrated), and a third sensor module 119), a camera module (e.g., a first camera device 105, a second camera device 112, and a flash 113), key input devices 117, a light-emitting element 106, and connector holes (e.g., a first connector hole 108 and a second connector hole 109). In an embodiment, in the electronic device 100, at least one of the components (e.g., the key input devices 117 or the light-emitting element 106) may be omitted, or other components may be additionally included.

The display 101 may output a screen or may be visually exposed through, for example, a significant portion of the first surface 110A (e.g., the front surface plate 102). In an embodiment, at least a portion of the display 101 may be visually exposed through the front surface plate 102 defining the first surface 110A or through a portion of the side surface 110C. In an embodiment, the periphery of the display 101 may be configured to be substantially the same as the shape of the periphery of the front surface plate 102 adjacent thereto. In an embodiment (not illustrated), the distance between the periphery of the display 101 and the periphery of the front surface plate 102 may be substantially constant in order to enlarge the visually exposed area of the display 101.

In an embodiment (not illustrated), recesses or openings may be provided in some portions of the screen display area of the display 101, and one or more of an audio module (e.g., the call receiver hole 114), a sensor module (e.g., the first sensor module 104), a camera module (e.g., the first camera module 105), and a light-emitting element 106 may be aligned with the recesses or the openings. In an embodiment (not illustrated), the rear surface of the screen display area of the display 101 may include at least one of an audio module (e.g., the call receiver hole 114), a sensor module (e.g., the first sensor module 104), a camera module (e.g., the first camera device 105), a fingerprint sensor (not illustrated), and a light-emitting element 106. In an embodiment (not illustrated), the display 101 may be coupled to or disposed adjacent to a touch-sensitive circuit, a pressure sensor capable of measuring a touch intensity (pressure), and/or a digitizer configured to detect an electromagnetic field-type stylus pen. In an embodiment, at least some of the sensor modules (e.g., the first sensor module 104 and the third sensor module 119) and/or at least some of the key input devices 117 may be disposed in in the first areas 110D, and/or the second areas 110E.

The audio module 103, 107, and 114 may include a microphone hole 103 and speaker holes (e.g., the external speaker hole 107 and the call receiver hole 114). The microphone hole 103 may include a microphone disposed therein to acquire external sound, and in an embodiment, multiple microphones may be disposed therein to be able to detect the direction of sound. The speaker holes may include an external speaker hole 107 and a call receiver hole 114. In an embodiment, the speaker holes (e.g., the external speaker hole 107 and the call receiver hole 114) and the microphone hole 103 are implemented as a single hole, or a speaker may be included without the speaker holes (e.g., the external speaker hole 107 and the call receiver hole 114) (e.g., a piezo speaker).

A sensor module may generate electrical signals or data values corresponding to the internal operating states or the external environmental states of the electronic device 100. The sensor modules may include, for example, a first sensor module 104 (e.g., a proximity sensor) and/or a second sensor module (not illustrated) (e.g., a fingerprint sensor) disposed on the first surface 110A of the housing 110, and/or a third sensor module 119 disposed on the second surface 110B of the housing 110. The second sensor module (not illustrated) (e.g., a fingerprint sensor) may be disposed not only on the first surface 110A (e.g., the display 101) of the housing 110, but also on the second surface 110B or the side surface 110C of the housing 110. The electronic device 100 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 104.

The camera module may include a first camera device 105 disposed on the first surface 110A of the electronic device 100 and a second camera device 112 disposed on the second surface 110B of the electronic device 100, and/or a flash 113. The camera devices (e.g., the first camera device 105 and the second camera device 112) may include one or more lenses, an image sensor, and/or an image signal processor. The flash 113 may include, for example, a light-emitting diode or a xenon lamp. In an embodiment, one or more lenses (e.g., an infrared camera lens, a wide-angle lens, and a telephoto lens) and image sensors may be disposed on one surface of the electronic device 100. In an embodiment, the flash 113 may emit infrared rays, and the infrared light emitted by the flash 113 and reflected by a subject may be received through the third sensor module 119. The electronic device 100 or the processor (e.g., the processor 1020 in FIG. 1) of the electronic device 100 may detect depth information of the subject based on a time point when the infrared rays are received by the third sensor module 119.

The key input devices 117 may be disposed on the side surface 110C of the housing 110. In an embodiment, the electronic device 100 may not include some or all of the above-mentioned key input devices 117, and a key input device 117, which is not included, may be implemented in another form, such as a soft key, on the display 101. In an embodiment, the key input devices may include a sensor module disposed on the second surface 110B of the housing 110.

The light-emitting element 106 may be disposed on, for example, the first surface 110A of the housing 110. The light-emitting element 106 may provide, for example, the state information of the electronic device 100 in an optical form. In an embodiment, the light-emitting element 106 may provide a light source that is interlocked with, for example, the operation of the camera module (e.g., the first camera device 105). The light-emitting element 106 may include, for example, an LED, an IR LED, and a xenon lamp.

The connector holes (e.g., a first connector hole 108 and a second connector hole 109) may include a first connector hole 108, which is capable of accommodating a connector (e.g., a USB connector) configured to transmit/receive power and/or data to/from an external electronic device (e.g., the electronic device 1002 in FIG. 1), and/or a second connector hole (e.g., an earphone jack) 109, which is capable of accommodating a connector for transmitting/receiving an audio signal to/from an external electronic device.

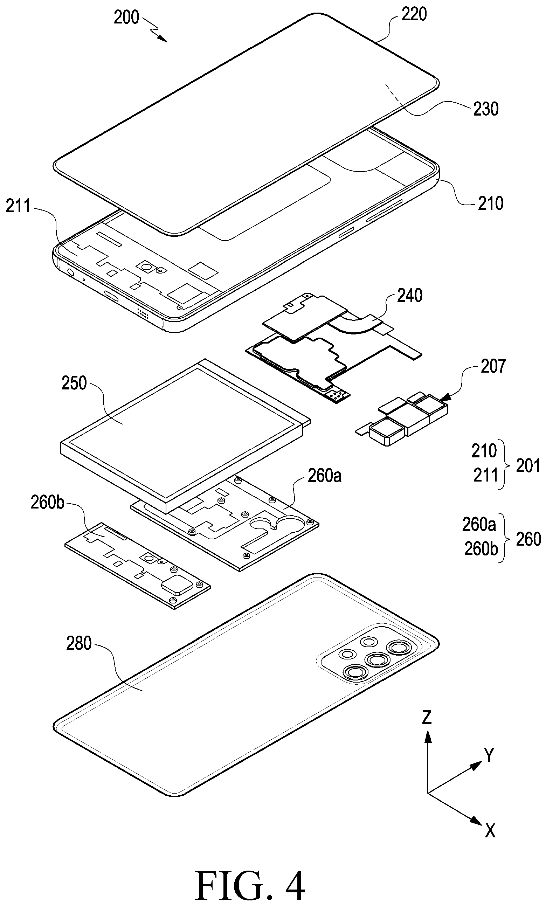

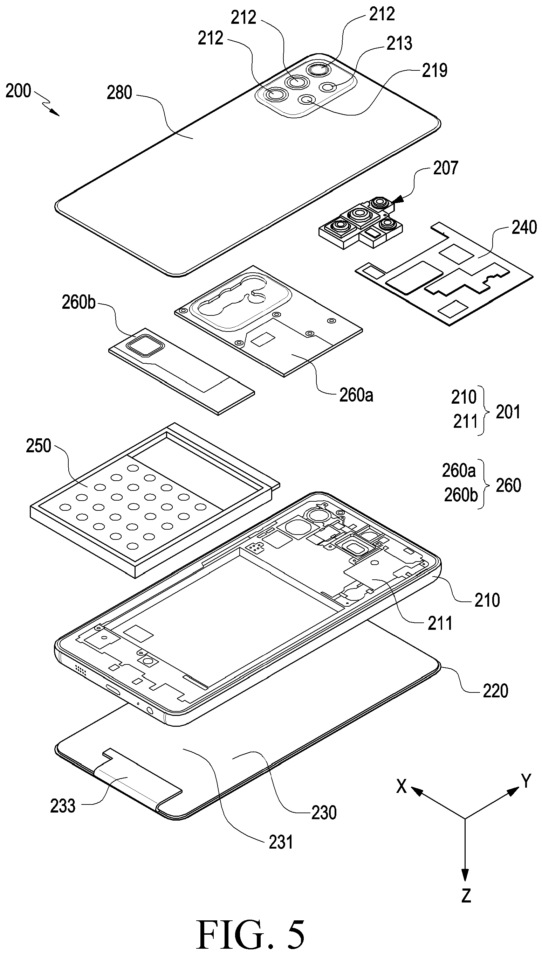

FIG. 4 is a front exploded perspective view illustrating the electronic device 200 according to an embodiment illustrated in the disclosure of FIG. 2. FIG. 5 is a rear exploded perspective view illustrating the electronic device 200 according to an embodiment illustrated in the disclosure of FIG. 2.

Referring to FIGS. 4 and 5, the electronic device 200 (e.g., the electronic device 1001, 1002, 1004, or 100 in FIG. 1, FIG. 2, or FIG. 3) may include a side structure 210, a first support member 211 (e.g., a bracket), a front surface plate 220 (e.g., the front surface plate 102 in FIG. 1), a display 230 (e.g., the display 101 in FIG. 1), a printed circuit board (or a substrate assembly) 240, a battery 250, a second support member 260 (e.g., a rear case), an antenna, a camera assembly 207, and a rear surface plate 280 (e.g., the rear surface plate 111 in FIG. 3). In an embodiment, in the electronic device 200, at least one of the components (e.g., the first support member 211 or the second support member 260) may be omitted, or other components may be additionally included. At least one of the components of the electronic device 200 may be the same as or similar to at least one of the components of the electronic device 100 of FIG. 2 or 3, and a redundant description thereof will be omitted below.

The first support member 211 may be disposed inside the electronic device 200 to be connected to the side structure 210 or may be integrated with the side structure 210. The first support member 211 may be made of, for example, a metal material and/or a non-metal (e.g., polymer) material. When at least partially being made of a metal material, a portion of the side structure 210 or the first support member 211 may serve as an antenna. The first support member 211 may include one surface to which the display 230 is coupled and the other surface to which the printed circuit board 240 is coupled. A processor (e.g., the processor 1020 in FIG. 1), a memory (e.g., the memory 1030 in FIG. 1), and/or an interface (e.g., the interface 1077 in FIG. 1) may be mounted on the printed circuit board 240. The processor may include at least one of, for example, a central processor, an application processor, a graphics processor, an image signal processor, a sensor hub processor, or a communication processor.

According to various embodiments, the first support member 211 and the side structure 210 may be combined to be referred to as a front case or a housing 201. According to an embodiment, the housing 201 may be generally understood as a structure for accommodating, protecting, or disposing the printed circuit board 240 or the battery 250. In an embodiment, it may be understood that the housing 201 includes structures that a user may visually or tactfully recognize in the exterior of the electronic device 200, such as the side structure 210, the front surface plate 220, and/or the rear surface plate 280. In an embodiment, the "front surface or rear surface of the housing 201" may be understood as the first surface 110A in FIG. 2 or the second surface 110B in FIG. 3. In an embodiment, the first support member 211 may be disposed between the front surface plate 220 (e.g., the first surface 110A in FIG. 2) and the rear surface plate 280 (e.g., the second surface 110B in FIG. 3) and may serve as a structure on which electrical/electronic components, such as a printed circuit board 240 or a camera assembly 207, are disposed.

The display 230 may include a display panel 231 and a flexible printed circuit board 233 extending from the display panel 231. The flexible printed circuit board 233 may be understood, for example, to be electrically connected to the display panel 231 while being disposed at least partially on the rear surface of the display panel 231. In an embodiment, reference number "231" may be understood as denoting a protective sheet disposed on the rear surface of the display panel. For example, unless otherwise classified in the following detailed description, the protective sheet may be understood to be a portion of the display panel 231. In an embodiment, the protective sheet may function as a buffer structure (e.g., a low-density elastic material such as a sponge) absorbing an external force or an electromagnetic shield structure (e.g., a copper sheet (CU sheet)). According to an embodiment, the display 230 may be disposed on the inner surface of the front surface plate 220 and may include a light-emitting layer to output a screen through at least a portion of the first surface 110A of FIG. 2 or the front surface plate 220. As mentioned above, the display 230 may output a screen through substantially the entire area of the first surface 110A of FIG. 2 or the front surface plate 220.

The memory may include, for example, a volatile memory or a non-volatile memory.

The interface may include, for example, a high-definition multimedia interface (HDMI), a universal serial bus (USB) interface, an SD card interface, and/or an audio interface. The interface may electrically or physically connect, for example, the electronic device 200 to an external electronic device and may include a USB connector, an SD card/an MMC connector, or an audio connector.

The second support member 260 may include, for example, an upper support member 260a and a lower support member 260b. In an embodiment, the upper support member 260a may be disposed to enclose the printed circuit board 240 together with a portion of the first support member 211. A circuit device implemented in the form of an integrated circuit chip (e.g., a processor, a communication module, or memory) or various electrical/electronic components may be disposed on the printed circuit board 240, and in some embodiments, the printed circuit board 240 may be provided with an electromagnetically shielded environment from the upper support member 260a. In an embodiment, the lower support member 260b may be used as a structure on which electric/electronic components such as a speaker module and an interface (e.g., a USB connector, an SD card/MMC connector, or an audio connector) may be disposed. In an embodiment, electrical/electronic components such as a speaker module and an interface (e.g., a USB connector, an SD card/MMC connector, or an audio connector) may be disposed on an additional printed circuit board (not illustrated). In this case, the lower support member 260b may be disposed to enclose the additional printed circuit board together with the other portion of the first support member 211. The speaker module or interface disposed on the additional printed circuit board (not illustrated) or the lower support member 260b may be disposed to correspond to the audio module (e.g., the microphone hole 103 or the speaker holes (e.g., the external speaker hole 107 and the call receiver hole 114)) or the connector holes (e.g., the first connector hole 108 and the second connector hole 109) of FIG. 2.

The battery 250 is a device for supplying power to at least one component of the electronic device 200 and may include, for example, a non-rechargeable primary battery, a rechargeable secondary battery, or a fuel cell. At least a portion of the battery 250 may be disposed on substantially the same plane as, for example, the printed circuit board 240. The battery 250 may be integrally disposed inside the electronic device 200, or may be disposed to be detachable from the electronic device 200.

Although not illustrated, the antenna may include a conductor pattern implemented on the surface of the second support member 260 through, for example, a laser direct structuring method. In an embodiment, the antenna may include a printed circuit pattern provided on the surface of a thin film, and the thin film-type antenna may be disposed between the rear surface plate 280 and the battery 250. The antenna may include, for example, a near-field communication (NFC) antenna, a wireless charging antenna, and/or a magnetic secure transmission (MST) antenna. The antenna may perform short-range communication with, for example, an external device, or may transmit/receive power required for charging to/from an external device in a wireless manner. In an embodiment, another antenna structure may be provided by a portion of the side structure 210 and/or the first support member 211or a combination thereof.

The camera assembly 207 may include at least one camera module. Inside the electronic device 200, the camera assembly 207 may receive at least some of light incident through optical holes or camera windows 212, 213, and 219. In an embodiment, the camera assembly 207 may be disposed on the first support member 211 at a position adjacent to the printed circuit board 240. In an embodiment, the at least one camera module of the camera assembly 207 may be generally aligned with one of the camera windows 212, 213, and 219, and may be at least partially enclosed by the second support member 260 (e.g., the upper support member 260a).

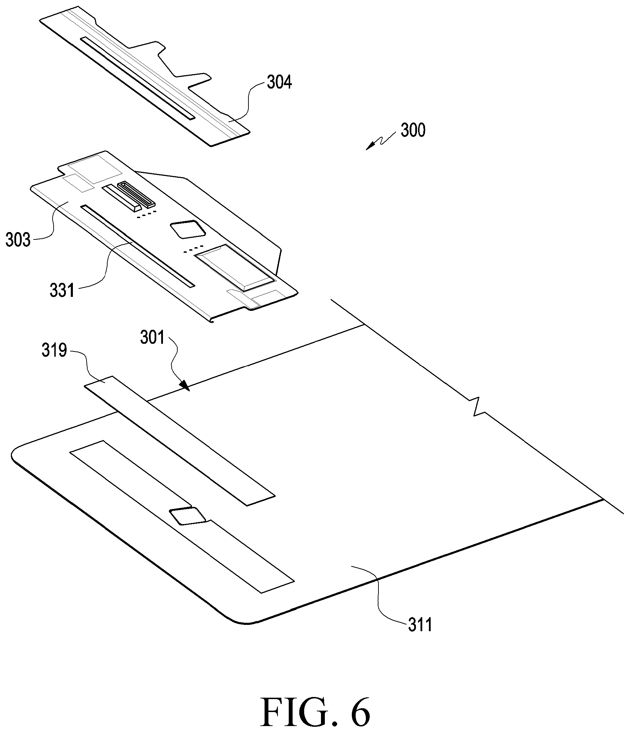

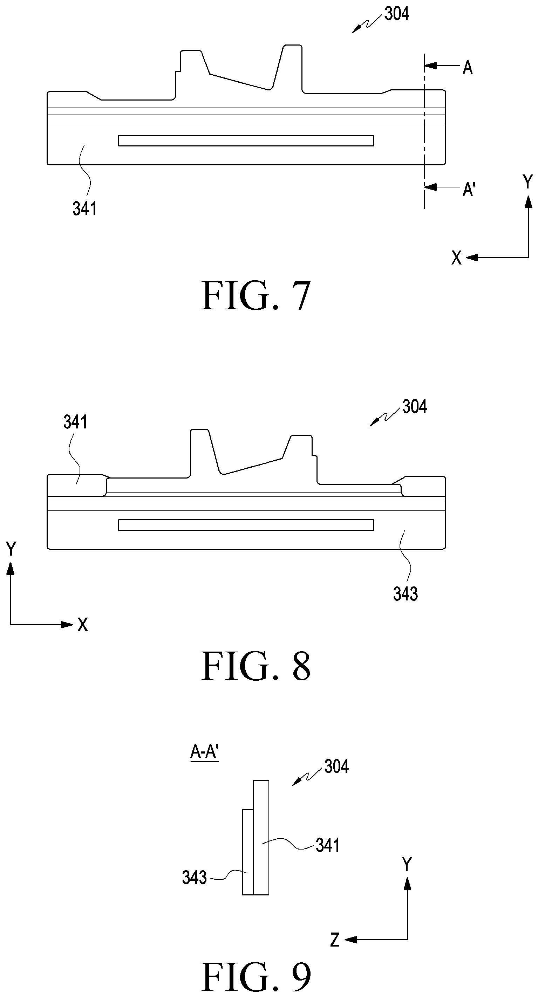

FIG. 6 is an exploded perspective view illustrating a display 300 (e.g., the display module 1060 of FIG. 1 or the display 101 or 230 of FIGS. 2, 4, and 5) of an electronic device (e.g., the electronic device 1001, 1002, 1004, 100, or 200 in FIGS. 1 to 5) according to an embodiment of the disclosure. FIG. 7 is a view illustrating a shield film 304 in the display 300 of the electronic device 200 according to an embodiment of the disclosure. FIG. 8 is a view illustrating the shield film 304 of FIG. 7 according to an embodiment of the disclosure. FIG. 9 is a view illustrating the shield film 304 according to an embodiment of the disclosure, cut along line A-A' in FIG. 7.

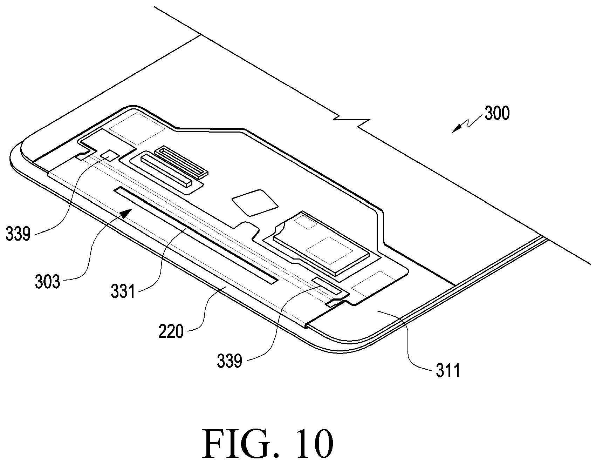

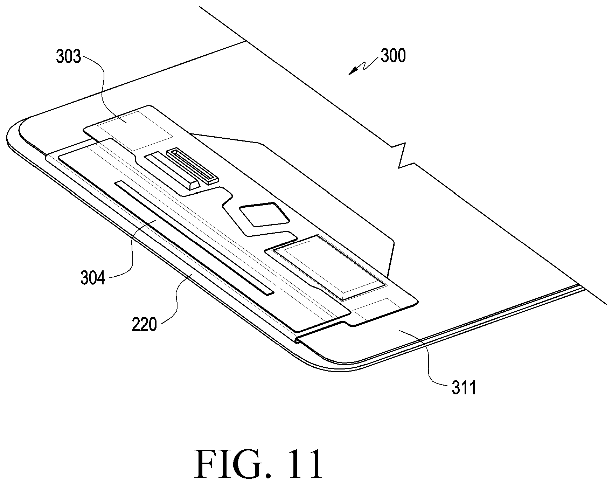

FIG. 10 is a perspective view illustrating a state in which a flexible printed circuit board 303 is disposed on a display panel 301 in the display 300 of the electronic device 200 according to an embodiment of the disclosure. FIG. 11 is a perspective view illustrating a state in which a shield film 304 is disposed on the flexible printed circuit board 303 in the display 300 of the electronic device according to an embodiment of the disclosure.

Referring to FIGS. 6 to 11, the display 300 (e.g., the display 230 of FIG. 5) may include a display panel 301, a flexible printed circuit board 303, and/or a shield film 304. The display panel 301 outputs a screen by including, for example, a light-emitting layer and may be disposed on the inner surface of a front surface plate (e.g., the front surface plate 220 of FIG. 4 or FIG. 5). In an embodiment, the display panel 301 may include a protective sheet 311 disposed on the rear surface thereof. By including, for example, a low-density elastic member or a metal sheet (e.g., a copper sheet), the protective sheet 311 may suppress or alleviate the direct application of an external force to the light-emitting layer or may suppress the external electromagnetic waves from interfering with the inside of the protective sheet 311.

According to an embodiment, the flexible printed circuit board 303 may include at least one electrical/electronic component (e.g., a display driver integrated circuit (DDI) 331) disposed on one surface. The DDI 331 may be controlled by, for example, a processor (e.g., the processor 120 of FIG. 1) to drive the display panel 301. Although not denoted by a reference numeral, the flexible printed circuit board 303 may further include other electrical/electronic components such as connectors or integrated circuit chips.

According to an embodiment, the display 300 may further include an adhesive layer 319 disposed between the display panel 301 (e.g., the protective sheet 311) and the flexible printed circuit board 303. The adhesive layer 319 may be, for example, a double-sided tape or adhesive. In an embodiment, the adhesive layer 319 may maintain at least a portion of the flexible printed circuit board 303 in a definite form by attaching at least a portion of the flexible printed circuit board 303 to the display panel 301 (e.g., the rear surface). Inside the electronic device 200, the flexible printed circuit board 303 may be disposed between the display panel 301 and a support member (e.g., the first support member 211 of FIG. 3 or FIG. 4).

According to an embodiment, the shield film 304 may be attached to one surface of the flexible printed circuit board 303 in a state of enclosing at least a portion of the DDI 331. For example, the shield film 304 may at least suppress exposure of the DDI 331 to external electromagnetic interference. In an embodiment, the shield film 304 may be electrically connected to the flexible printed circuit board 303. For example, the shield film 304 may be electrically connected to a ground conductor of the flexible printed circuit board 303 to implement an electromagnetic shield structure and to function as a ground conductor providing a reference potential. In an embodiment, the flexible printed circuit board 303 may include at least one relief area 339 exposing the ground conductor to the external space to allow the shield film 304 to be electrically connected with the ground conductor.

According to an embodiment, the shield film 304 may include a shield layer 341 and an insulating layer 343 provided on one surface of the shield layer 341. In an embodiment, the insulating layer 343 may provide an adhesive function for attaching the shield layer 341 to the flexible printed circuit board 303. In an embodiment, the shield film 304 may further include an adhesive material in addition to the insulating layer 343, and the insulating layer 343 and/or the shield layer 341 may be attached to the flexible printed circuit board 303 by the adhesive material. In an embodiment, the shield layer 341 may have a shape extending further to the outside of the insulating layer 343, and the portion of the shield layer 341 extending further to the outside of the insulating layer 343 may come into direct contact with the ground conductor of the flexible printed circuit board 303 while passing through the relief area 339.

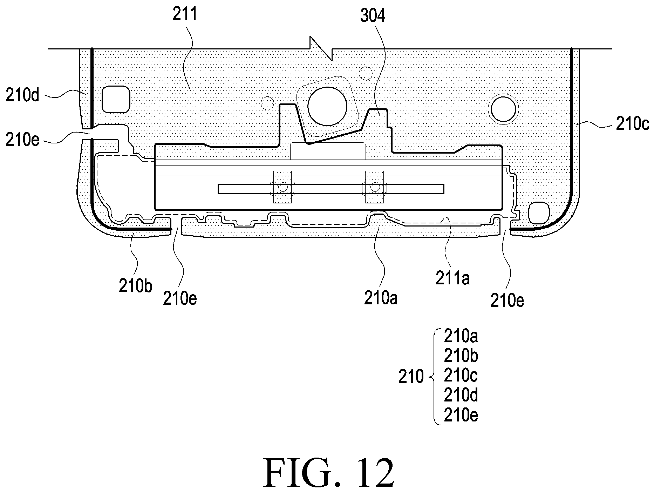

FIG. 12 is a view illustrating an arrangement of the side structure 210 or the support member (e.g., the first support member 211) and the shield film 304 in the electronic device 200 according to an embodiment of the disclosure.

Referring to FIG. 12, the side structure 210 and/or the first support member 211 may be at least partially made of a metal or electrically conductive material and may function as an antenna in an electronic device (e.g., the electronic device 1001, 1002, 1004, 100, or 200 of FIGS. 1 to 5). For example, a processor (e.g., the processor 120 of FIG. 1) or a communication module (e.g., the communication module 190 of FIG. 1) may use at least a portion of the side structure 210 or the first support member 211 to execute wireless communication. A portion of the side structure 210 or the first support member 211 used for wireless communication may be insulated from other electrically conductive material portions.

According to an embodiment, the portions indicated by solid lines in the side structure 210 or the first support member 211 in FIG. 12 may be electrically conductive material portions, and the portion indicated by reference number "211a" may be an example of an insulative material portion or a synthetic material portion in the side structure 210 or the first support member 211. For example, in the side structure 210, at least a portion indicated by reference numeral "210a" or "210b" (hereinafter, referred to as a "first radiation conductor 210a" or a "second radiation conductor 210b") may be electrically connected to a processor (e.g., the processor 120 of FIG. 1) or a communication module (e.g., the communication module 190 of FIG. 1) to function as a radiation conductor. In an embodiment, the side structure 210 generally has a frame shape surrounding the periphery of the first support member 211, and the electrically conductive material portion of the side structure may be partially separated to be insulated from another electrically conductive material portion (e.g., the portion denoted by reference numeral "210c" or "210d"), thereby providing the first radiation conductor 210a or the second radiation conductor 210b.

According to an embodiment, the insulating material portion or synthetic resin material portion 211a may be provided to enclose at least a portion of an electrically conductive material portion (e.g., the first radiation conductor 210a or the second radiation conductor 210b) and may connect the electrically conductive material portion to another electrically conductive material portion (e.g., the first support material 211 or the portion denoted by reference numeral "210c" or "210d" in the side structure 210). In an embodiment, the insulative material portion or the synthetic resin material portion 211a may be understood as substantially a portion of the first support member 211 or the side structure 210. For example, when the side structure 210 is divided into multiple portions 210a, 210b, 210c, and 210d to provide the first radiation conductor 210a or the second radiation conductor 210b, an insulative material portion or a synthetic resin material portion 211a may be disposed to a slot portion 210e between the electrically conductive portions (e.g., the first radiation conductor 210a or the second radiation conductor 210b) of the side structure 210 to provide a mechanical connection structure.

According to an embodiment, the flexible printed circuit board 303 or the shield film 304 of the display 300 may be disposed adjacent to the first radiation conductor 210a or the second radiation conductor 210b. For example, the first radiation conductor 210a may extend or be disposed to be parallel to the display 300 at a position at least partially adjacent to the DDI 331. In an embodiment, the shield film 304 may provide an electromagnetically shielded environment between the DDI 331 and the first radiation conductor 210a or between the DDI 331 and the second radiation conductor 210b. For example, even when disposed adjacent to an antenna (e.g., the first radiation conductor 210a or the second radiation conductor 210b), the DDI 331 may be provided with an electromagnetically shielded environment, and the first radiation conductor 210a or the second radiation conductor 210b may execute stable wireless communication in the state in which the influence of the DDI 331 is suppressed.

According to an embodiment, the DDI 331 or the shield film 304 may be disposed adjacent to the first radiation conductor 210a or the second radiation conductor 210b of the side structure 210. For example, in the process of performing wireless communication or while the display 300 is operating, electromagnetic interference may be caused between the DDI 331 and the first radiation conductor 210a (or the second radiation conductor 210b). By being disposed to substantially enclose the DDI 331, the shield film 304 may provide an electromagnetically shielded environment between the DDI 331 and the first radiation conductor 210a (or the second radiation conductor 210b). For example, even if wireless communication and driving of the display 300 are performed simultaneously, the shield film 304 may provide a stable operating environment for the DDI 331 and the radiation conductors 210a and 210b.

According to an embodiment, the shield film 304 has a specified degree of flexibility while being disposed on one surface of the flexible printed circuit board 303 on which the DDI 331 is disposed so that the shield film 304 can be deformed on the one surface of the flexible printed circuit board 303 to correspond to bending caused by the DDI 331. For example, when attached to the one surface of the flexible printed circuit board 303, the shield film 304 may be stably in close contact with the surface of the flexible printed circuit board 303 and the surface of the DDI 331. In an embodiment, since the shield film 304 has flexibility, the shield film 304 may form air pockets when air remains in the attachment area in the process of attaching the shield film to the flexible printed circuit board 303. Here, the term "attachment area" may refer to an area to which the shield film 304 is attached on the flexible printed circuit board 303, for example, an area corresponding to the shape of the shield film 304 illustrated in FIG. 6 or FIG. 12 on the one surface of the flexible printed circuit board 303. For example, the area denoted by reference numeral "304" in FIG. 12 may illustrate a position where the attachment area of the flexible printed circuit board 303 is substantially disposed on the first support member 211 or the side structure 210.

According to an embodiment, when disposed in an electromagnetic field, the shield film 304 may change the distribution of the electromagnetic field or may form capacitive (or inductive) coupling with an adjacent electrically conductive structure or component. For example, when a wireless signal is transmitted/received via the first radiation conductor 210a or the second radiation conductor 210b, the shield film 304 may form a capacitive coupling with the first radiation conductor 210a or the second radiation conductor 210b. In an embodiment, when forming capacitive coupling with the first radiation conductor 210a or the second radiation conductor 210b, the shield film 304 may form an additional capacitive coupling with another adjacent electrically conductive structure (e.g., a metal structure of an electrically conductive portion of the first support member 211 or a fastening boss embedded in the synthetic resin material portion 211a).

According to an embodiment, in the design or arrangement of the shield film 304, such capacitive coupling(s) may be considered. For example, considering that a capacitive coupling is generated when the first radiation conductor 210a or the second radiation conductor 210a and the shield film 304 are disposed adjacent to each other, the degradation wireless communication performance may be suppressed or compensated by using an additional capacitive coupling. In an embodiment of the disclosure, a configuration in which a capacitive coupling is generated according to the arrangement of the shield film 304 is disclosed, but it is noted that one or more embodiments of the disclosure are not limited thereto. For example, as mentioned above, depending on the arrangement of the shield film, an inductive coupling may be generated or the distribution of the electromagnetic field may change.

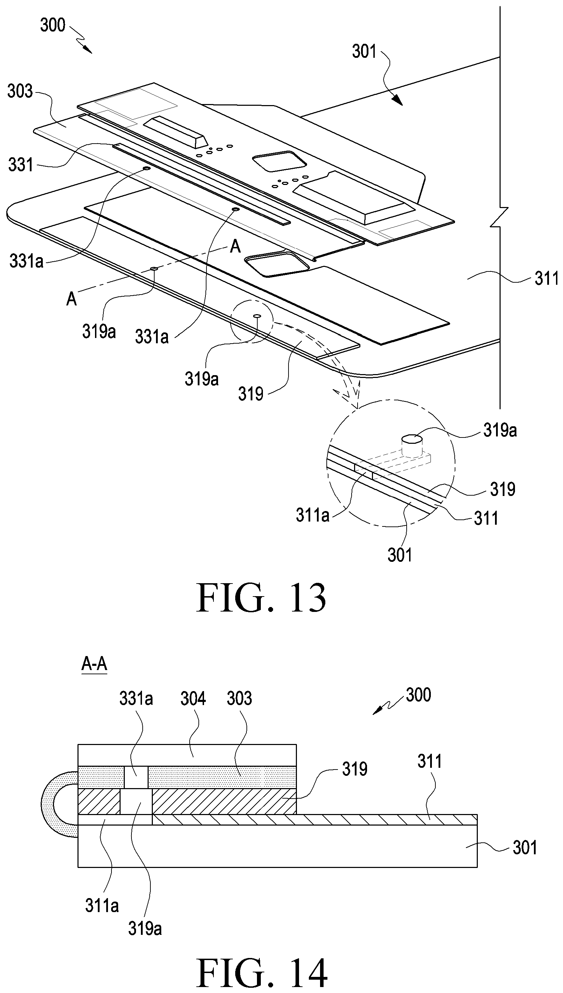

According to an embodiment, in attaching the shielding member 304 to the flexible printed circuit board 303, it may be difficult to predict whether or not air pockets are generated and the locations or sizes of the air pockets. When air pockets are generated in the process of attaching the shield film 304, the shield film 304 may be disposed to be substantially different from design specifications. For example, in the arrangement of the shield film 304, the distance (or relative position) from the radiation conductors 210a and 210b or other adjacent electrically conductive structures may be different from the design. In an embodiment, when the shield film 304 is arranged at a distance different from a design specification with respect to the electrically conductive structure, a capacitive coupling or inductive coupling considered in the design process or a change in distribution of electromagnetic field due to the arrangement of the shield film 304 may not be implemented in an actually completed electronic device 200. In this case, in wireless communication, the radiation conductors 210a and 210b may not be able to implement wireless communication performance required by the electronic device 200. According to one or more embodiments of the disclosure, by suppressing generation of air pockets in disposing the shield film 304 on the flexible printed circuit board 303, the arrangement or wireless communication performance of the shield film 304 in the electronic device 200 may conform to the design specification. A configuration in which generation of air pockets is suppressed when the shield film 304 is attached to the flexible printed circuit board 303 will be described with reference to FIGS. 13 to 22.

FIG. 13 is a drawing illustrating an arrangement of through holes 331a and 319a or recesses 311a in a display 300 (e.g., the display module 1060 in FIG. 1 or a display 101 or 230 in FIGS. 2, 4, and 5) of an electronic device (e.g., the electronic device 1001, 1002, 1004, 100, or 200 in FIGS. 1 to 5) according to an embodiment of the disclosure. FIG. 14 is a view for explaining an arrangement of through holes 331a and 319a or a recess 311a in a display 300 of an electronic device 200 according to an embodiment of the disclosure.

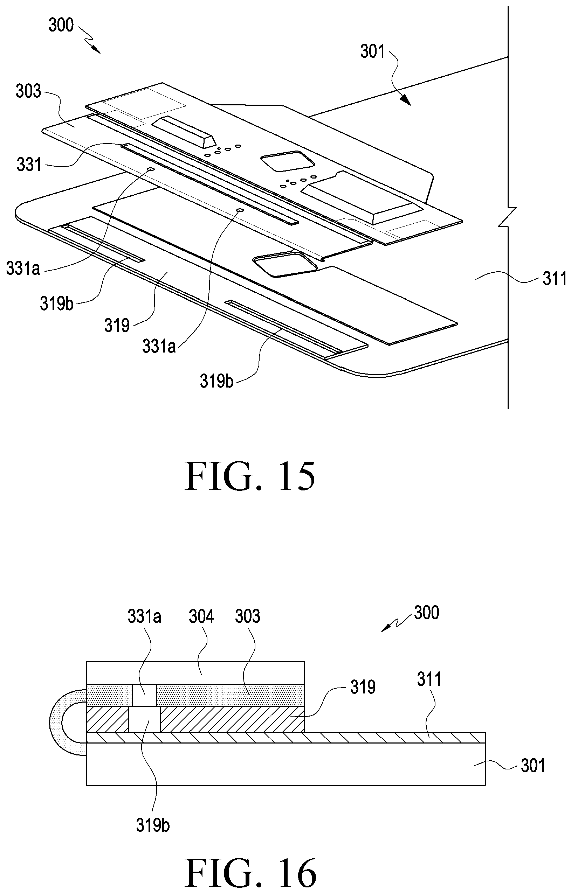

Referring to FIGS. 13 and 14, the display 300 and/or the electronic device 200 may include at least one through hole 331a disposed in the attachment area (e.g., the area in which the shield film 304 of FIGS. 6, FIG. 12, or FIG. 14 is attached) on the flexible printed circuit board 303. As will be described later, the display 300 and/or the electronic device 200 may further include at least one recess (e.g., the recess 311a in FIG. 14) or at least one slit (e.g., the slits 319b of FIG. 15 to be described later) at least partially disposed in the attachment area. For example, the at least one recess 311a or the at least one slit 319b may be disposed across an edge of the attachment area or to be exposed at an edge of the attachment area. For example, the at least one recess 311a or the at least one slit 319b may extend from the inside of the attachment area to the outside of the attachment area across an edge of the attachment area. According to the invention as claimed, when the shield film 304 is attached to the flexible printed circuit board 303, the through holes 331a and 319a, the at least one recess 311a, and/or the at least one slit 319b function as air discharge passages. For example, when the shield film 304 is disposed on the flexible printed circuit board 303, generation of air pockets may be suppressed. After the shield film 304 is disposed on the flexible printed circuit board 303, the through holes 331a and 319a, the at least one recess 311a, and/or the at least one slit 319b may be closed by an adhesive material or the shield film 304 itself. For example, after the attaching process, there may be substantially no air between the shield film 304 and the flexible printed circuit board 303. In an embodiment, after the attachment process, a certain amount of air may be present on the attachment area, but this is air present in the spaces implemented by the through holes 331a and 319a, the at least one recess 311a, and/or the at least one slit 319b. Thus, substantially no air may be present between the shield film 304 and the flexible printed circuit board 303.

According to an embodiment, the display 300 and/or the electronic device 200 may include a protective sheet 311 disposed on the rear surface of the display panel 301. In an embodiment, the flexible printed circuit board 303 may be attached to the rear surface (e.g., the protective sheet 311) of the display panel 301 by an adhesive layer 319 at an edge of the display panel 301. In the illustrated embodiment, two through holes 331a may be disposed through the flexible printed circuit board 303 in the attachment area. However, one or more embodiments of the disclosure are not limited thereto, and a smaller or greater number of through holes 331a may be provided through the flexible printed circuit board 303 in consideration of the attachment area of the shield film 304 and the arrangement of electrical/electronic components (e.g., the DDI 331) within the attachment area.

According to an embodiment, the number of through holes may be even. According to an embodiment, the through holes may have the same shape. According to an embodiment, the through holes may have the same size. According to an embodiment, the through holes are arranged symmetrically with respect to a center line that extends parallel to the longer sides of the display (electronic device). This symmetric arrangement allows for efficient discharge of air.

According to an embodiment, the number, positions and size of the through holes should be selected to be large enough that air can be effectively discharge as well as small enough to maintain a sufficiently large attachment (contact) area (between shield film and printed circuit board) (or between printed circuit board and adhesive layer) (or between protective sheet and adhesive layer).

According to an embodiment, the total size (surface area) of all through holes (in any one of printed circuit board, protective sheet and adhesive layer) ranges between 0.1% and 30%, more preferably between 0.3% and 20 %, more preferably between 0.5% and 15% and still more preferably between 1% and 10% of the total surface area (of the respective one of printed circuit board, protective sheet and adhesive layer) which overlap with the shield film. Overlapping means an overlap of a projection of the shield film onto the respective one of printed circuit board, protective sheet and adhesive layer along an axis which is perpendicular to the planar top surface of the shield film. These surface area ratios allow for efficient discharge of air.

According to an embodiment, the above considerations regarding the arrangement, number, position, size and surface area ratios of the through holes also apply to the slits in the same way.

According to an embodiment, the adhesive layer 319 may define a slot or a second through hole 319a disposed to at least partially correspond to a through hole 331a. The second through hole 319a may be connected to, for example, the through hole 331a to function as a portion of an air discharge passage. In an embodiment, the protective sheet 311 may at least partially define at least one recess 311a (or slit) at least partially corresponding to the through hole 331a and/or the second through hole 319a. The at least one recess 311a defined by the protective sheet 311 may be disposed across an edge of the attachment area, for example, by being connected to the through hole 331a and/or the second through hole 319a at one end thereof and extending along a predetermined direction. The description "disposed across an edge of the attachment area" may be understood to include a state in which the at least one recess 311a is opened or exposed to the outside at an edge of the attachment area. For example, while the shield film 304 is being attached to the flexible printed circuit board 303, the air present between the shield film 304 and the flexible printed circuit board 303 may be discharged to the outside sequentially via the through hole 331a, the second through hole 319a and/or the recess 311a. As a result, even when the shield film 304 is attached to the flexible printed circuit board 303, generation of air pockets may be suppressed in the attachment area, and even when the shield film 304 is disposed adjacent to the radiation conductors (e.g., the first radiation conductor 210a and the second radiation conductor 210b in FIG. 12), since the shield film 304 is already disposed on the flexible printed circuit board 303 to meet a design specification, deterioration of the radio signal transmission/reception performance of the radiation conductors (e.g., the first radiation conductor 210a and the second radiation conductor 210b in FIG. 12) may be suppressed.

According to an embodiment, the second through hole 319a and/or the recess 311a may be omitted from the structure in which the shield film 304 is already attached to the flexible printed circuit board 303 before the flexible printed circuit board 303 is attached to the rear surface of the display panel 301. In an embodiment, even when the shield film 304 is already attached to the flexible printed circuit board 303 before the flexible printed circuit board 303 is attached to the rear of the display panel 301, since the second through hole 319a and/or the recess 311a are arranged, generation of air pockets between the flexible printed circuit board 303 and the display panel 301 may be suppressed. For example, regardless of before and after attachment, since the through hole 331a, the second through hole 319a, and/or the recess 311a are disposed in the attachment area of the shield film 304 and the flexible printed circuit board 303 and/or the attachment area of the flexible printed circuit board 303 and the display panel 301, generation of air pockets in the attachment areas may be suppressed and wireless communication performance that meets a design specification may be implemented.

FIG. 15 is a view illustrating an arrangement of through holes 331a and slits 319b in a display 300 (e.g., the display module 1060 in FIG. 1 or a display 101 or 230 in FIGS. 2, 4, and 5) of an electronic device (e.g., the electronic device 1001, 1002, 1004, 100, or 200 in FIGS. 1 to 5) according to an embodiment of the disclosure. FIG. 16 is a view for explaining an arrangement of a through hole 331a or a slit 319b in a display 300 of an electronic device 200 according to an embodiment of the disclosure.

Referring to FIGS. 15 and 16, the display 300 may be different from that of the embodiment of FIG. 13 and/or FIG. 14 in the structure in which the recesses (e.g., the recesses 311a in FIG. 13) or slits in the protective sheet are omitted and the slits 319b are provided in the adhesive layer 319. For example, as illustrated in FIGS. 15 and 16, a slit 319b may extend from a position corresponding to a through hole 331a across an edge of an attachment area (e.g., the attachment area of the adhesive layer 319). In an embodiment, one end of the slit 319b may be opened to the outside at an edge of the adhesive layer 319. In an embodiment, the one end of the slit 319b may be opened to the external space substantially at an edge of the flexible printed circuit board 303.

According to an embodiment, while the shield film 304 is being attached to the flexible printed circuit board 303, the air present between the shield film 304 and the flexible printed circuit board 303 may be discharged to the outside sequentially via the through hole 331a and/or the slit 319b. As a result, even when the shield film 304 is attached to the flexible printed circuit board 303, it is possible to suppress generation of air pockets in the attachment area, and even when the shield film 304 is disposed adjacent to the radiation conductors (e.g., the first radiation conductor 210a and the second radiation conductor 210b in FIG. 12), deterioration of the radio signal transmission/reception performance of the radiation conductors (e.g., the first radiation conductor 210a and the second radiation conductor 210b in FIG. 12) may be suppressed.

According to an embodiment, the slit 319b may be omitted from the structure in which the shield film 304 is already attached to the flexible printed circuit board 303 before the flexible printed circuit board 303 is attached to the rear surface of the display panel 301. For example, depending on whether or not the slit 319b is included, the order of attaching the shield film 304, the flexible printed circuit board 303, and/or the display panel 301 may be appropriately selected. The attaching order or whether the slit 319b is included may be similar to that in the embodiment of FIG. 13 and/or FIG. 14, and thus a detailed description thereof will be omitted.

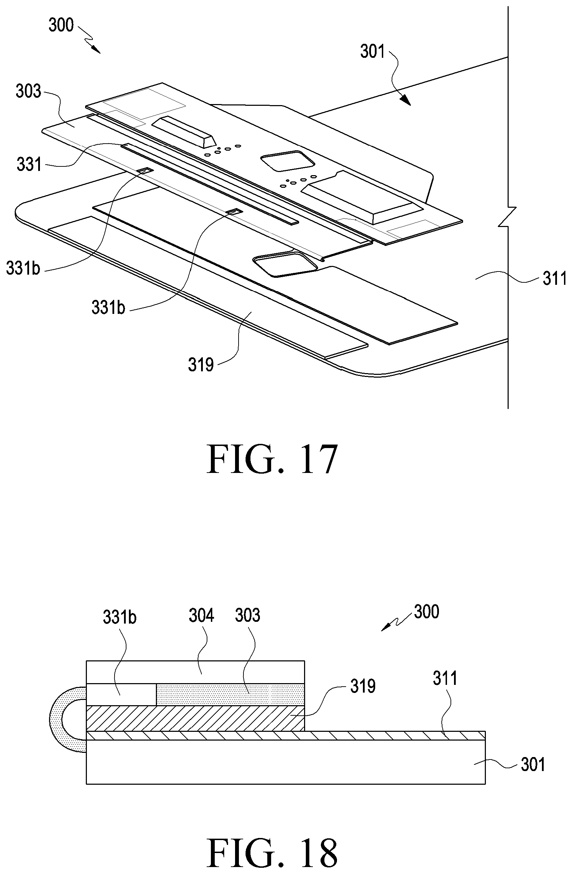

FIG. 17 is a view illustrating an arrangement of through slits 331b in a display 300 (e.g., the display module 1060 in FIG. 1 or a display 101 or 230 in FIGS. 2, 4, and 5) of an electronic device (e.g., the electronic device 1001, 1002, 1004, 100, or 200 in FIGS. 1 to 5) according to an embodiment of the disclosure. FIG. 18 is a view for explaining an arrangement of a slit 331b in a display 300 of an electronic device 200 according to an embodiment of the disclosure.

Referring to FIGS. 17 and 18, the second through holes 319a, the recesses 311a and/or the slits 319b of FIGS. 13 to 16 may be omitted, and the display 300 may include a second slit 331b provided in a flexible printed circuit board 303. In an embodiment, when second slits 331b are provided in the flexible printed circuit board 303, through holes (e.g., the through holes 331a of FIG. 13 or FIG. 14) may be omitted, and the second slits 331b themselves may be provided to extend through both surfaces of the flexible printed circuit board 303, whereby at least some of the through holes 331a of FIG. 13 or FIG. 14 may be included. Although not illustrated, in an embodiment, a second slit 331b may be implemented as a recess provided on one surface of a flexible printed circuit board 303 without extending through both surfaces of the flexible printed circuit board 303. In this case, even if the through holes 331a of FIG. 13 or FIG. 14 is omitted, a passage for discharging air may be provided as the second slits 331b themselves in one surface of the flexible printed circuit board 303.

According to an embodiment, a second slit 331b may extend from any one of through holes (e.g., the through holes 331a of FIG. 13). For example, the second slit 331b may be provided in the other surface of the flexible printed circuit board 303, may be connected to a through hole in an attachment area, and may extend across an edge of the attachment area. In an embodiment, the second slit 331b may have an open end at one edge of the flexible printed circuit board 303. It is noted, however, that the one or more embodiments of the disclosure are not limited thereto. For example, when the shield member 304 has a smaller size than the flexible printed circuit board 303 so that an edge of the attachment area is spaced apart from an edge of the flexible printed circuit board 303 by a predetermined distance, the second split 331b may be implemented such that the opposite ends thereof are substantially covered by the flexible printed circuit board 303 by disposing one end of the second slit 331b outside the attachment area and disposing the other end inside the attachment area on the flexible printed circuit board 303.

According to an embodiment, although not illustrated, the flexible printed circuit board 303 may include wiring lines electrically connecting the DDI 331 and the display panel 301. The number, positions, or width of second slits 331b may be determined in consideration of an area where the wiring lines are disposed or trajectories of the wiring lines extend on the flexible printed circuit board 303. For example, compared to the embodiments of FIGS. 13 to 16, there may be some restrictions in providing recesses or slits (e.g., the second slits 331b) in the flexible printed circuit board 303 itself. According to an embodiment, by providing the second slits 331b, generation of air pockets in an attachment area between the shield film 304 and the flexible printed circuit board 303 or an attachment area between the flexible printed circuit board 303 and the display panel 301 may be suppressed. For example, a radiation conductor (e.g., the first radiation conductor 210a and the second radiation conductor 210b of FIG. 12) may provide wireless signal transmission/reception performance that meets a design specification even when the flexible printed circuit board 303 or the shield film 304 is disposed adjacent thereto.

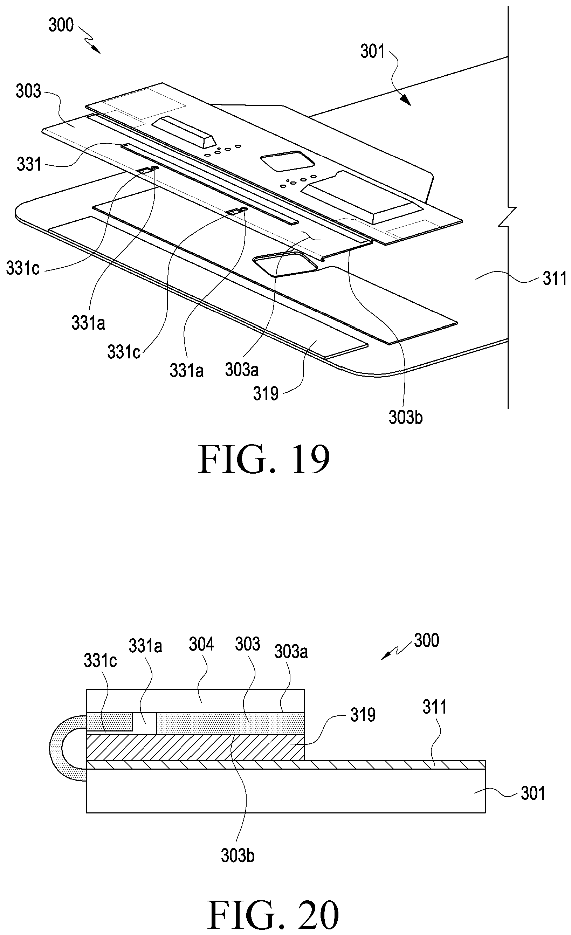

FIG. 19 is a view illustrating an arrangement of through holes 331a and recesses 331c in a display 300 (e.g., the display module 1060 in FIG. 1 or a display 101 or 230 in FIGS. 2, 4, and 5) of an electronic device (e.g., the electronic device 1001, 1002, 1004, 100, or 200 in FIGS. 1 to 5) according to an embodiment of the disclosure. FIG. 20 is a view for explaining an arrangement of a through hole 331a or a recess 331c in a display 300 of an electronic device 200 according to an embodiment of the disclosure.

Referring to FIGS. 19 and 20, a display 300 may include at least one through hole 331a formed in a flexible printed circuit board 303 and at least one second recess 331c extending from the at least one through-hole 331a. By disposing the at least one second recess 331c in one surface of the flexible printed circuit board 303 (e.g., the surface denoted by reference numeral "303b") opposite to the surface on which a shield film 304 is disposed (e.g., the surface denoted by reference numeral "303b"), the at least one second recess 331c may function as a passage for discharging air between the shield film 304 and the flexible printed circuit board 303 even when the shield film 304 is disposed. In disposing the at least one the second recess 331c, the trajectories or positions of the wiring lines of the flexible printed circuit board 303 may be considered. In an embodiment, although not illustrated, at least one second recesses 331c may be omitted, and at least one mesh structure may be disposed to correspond to the position or trajectory of the at least one second recess 331c. The mesh structure is, for example, a mesh-shaped structure and may be interposed between the flexible printed circuit board 303 and the adhesive layer 319 (or the display panel 301) to form a predetermined gap or maintain a predetermined gap. For example, by maintaining a predetermined gap between the flexible printed circuit board 303 and the adhesive layer 319 (or the display panel 301) while being connected to the through hole 331a, the at least one second recess 331c or the at least one mesh structure may function as a passage for discharging air with the through hole 331a. In an embodiment, the at least one second recess 331c or the at least one mesh structure may be exposed to the external space substantially at an edge of the flexible printed circuit board 303 or the adhesive layer 319.

According to an embodiment, while the shield film 304 is being attached to the flexible printed circuit board 303, the air present between the shield film 304 and the flexible printed circuit board 303 may be discharged to the outside sequentially via the through hole 331a and/or the second recess 331c (or the mesh structure). As a result, even when the shield film 304 is attached to the flexible printed circuit board 303, it is possible to suppress generation of air pockets in the attachment area, and even when the shield film 304 is disposed adjacent to the radiation conductors (e.g., the first radiation conductor and the second radiation conductor in FIG. 12), deterioration of the radio signal transmission/reception performance of the radiation conductors (e.g., the first radiation conductor and the second radiation conductor in FIG. 12) may be suppressed.

According to an embodiment, the second recess 331c or the mesh structure may be omitted from the structure in which the shield film 304 is already attached to the flexible printed circuit board 303 before the flexible printed circuit board 303 is attached to the rear surface of the display panel 301. The configuration for suppressing generation of air pockets between the shield film 304 and the flexible printed circuit board 303 or between the flexible printed circuit board 303 and the display panel 301 may be similar to that in the embodiment of FIG. 13 and/or FIG. 14, and thus, a detailed description thereof will be omitted.

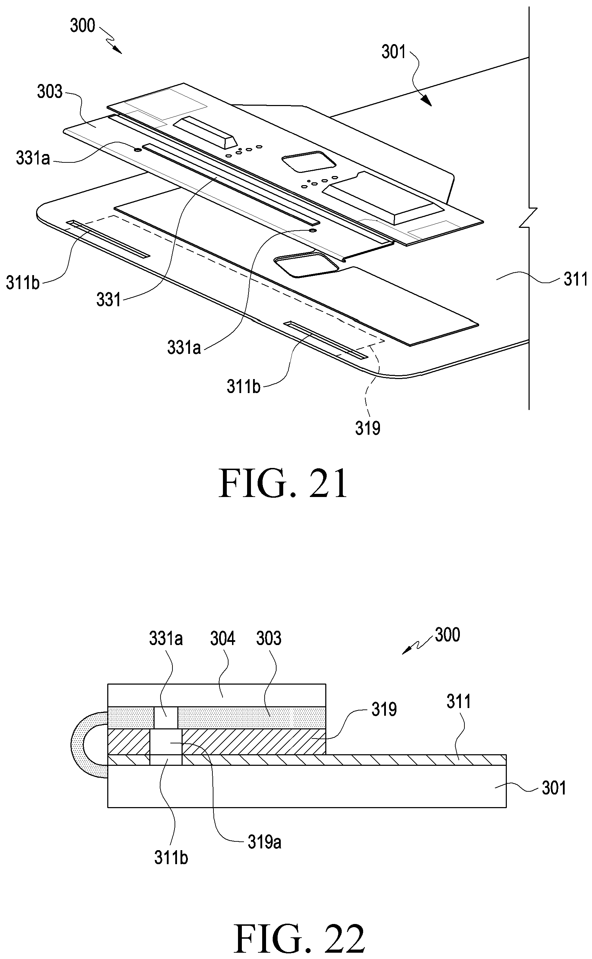

FIG. 21 is a view illustrating an arrangement of through holes 331a and slits 311b in a display 300 (e.g., the display module 1060 in FIG. 1 or a display 101 or 230 in FIGS. 2, 4, and 5) of an electronic device (e.g., the electronic device 1001, 1002, 1004, 100, or 200 in FIGS. 1 to 5) according to an embodiment of the disclosure. FIG. 22 is a view for explaining an arrangement of through holes 331a and 319a or a slit 311b in a display 300 of an electronic device 200 according to an embodiment of the disclosure.

Referring to FIGS. 21 and 22, the display 300 is similar to that in the embodiment of FIG. 13 or FIG. 14, but a third recess or a third slit 311b may be defined by a protective sheet 311 and opposite ends of the third slit 311b may be closed by a protective sheet 311. In an embodiment, the third slit 311b may substantially extend through both surfaces of the protective sheet 311 and may be disposed to partially correspond to a through hole 331a in an attachment area. In an embodiment, the third slit 311b may be disposed across an edge of the attachment area and/or an edge of the flexible printed circuit board 303. For example, the third slit 331b is generally covered by the flexible printed circuit board 303, but at least a portion of the third slit 311b may be exposed to the external space, rather than being substantially covered by the flexible printed circuit board 303. In a structure in which the third slit 311b is disposed in a display panel 301 or a protective sheet 311, the adhesive layer 319 may provide a second through hole 319a corresponding to the through hole 331a. For example, when the shield film 304 is attached to the flexible printed circuit board 303, the through hole 331a, the second through hole 319a and/or the third slit 311b may function as a discharge passage for air. As a result, when the shield film 304 is disposed on the flexible printed circuit board 303, generation of air pockets may be suppressed, and deterioration of the radio signal transmission/reception performance of the radiation conductors (e.g., the first radiation conductor 210a and the second radiation conductor 210b in FIG. 12) may be suppressed.

According to one or more embodiments of the disclosure, generation of air pockets in an attachment region of the shield film 304 and the flexible printed circuit board 303 may be suppressed. When a flexible printed circuit board 303 including at least one electrical/electronic component (e.g., a display driver integrated circuit (DDI) 331) is disposed adjacent to a structure that generates an electromagnetic field such as a radiation conductor (e.g., the first radiation conductor 210a and the second radiation conductor 210b of FIG. 12), the shield film 304 may create capacitive or inductive coupling or may change the distribution of the generated electromagnetic field. For example, a wireless signal transmission/reception environment may change depending on the arrangement of the shield film 304. In an embodiment, by suppressing generation of air pockets in the attachment process of the shield film 304, the wireless signal transmission/reception environment may be suppressed from being changed to be different from a design specification. When an electronic device (e.g., the electronic device 1001, 1002, 1004, 100, or 200 in FIGS. 1 to 5) is downsized, a change in a wireless communication environment may increase depending on an arrangement of the shield film 304. One or more embodiments of the disclosure may improve the degree of freedom in design and arrangement of antennas or radiation conductors (e.g., the first radiation conductor 210a and the second radiation conductor 210b in FIG. 12) by suppressing a change in a wireless communication environment while disposing a shield film 304.

Effects that are capable of being obtained by the disclosure are not limited to those described above, and other effects not described above may be clearly understood by a person ordinarily skilled in the art to which the disclosure belongs based on the following description.

As described above, according to an embodiment, a display (e.g., the display module 1060 of FIG. 1 or the display module 101, 230, or 300 in FIG. 2, FIGS. 4 to 6, FIG. 10, FIG. 11, and FIGS. 13 to 21) may include a display panel (e.g., the display 301 of FIG. 6, FIG. 10, FIG. 11, and FIGS. 13 to 21) including a light-emitting layer, a flexible printed circuit board (e.g., the flexible printed circuit board 303 in FIG. 6, FIG. 10, FIG. 11, and FIGS. 13 to 21) extending from the display panel and at least partially disposed on a rear surface of the display panel, a display driver integrated circuit ("DDI") (the display driver integrated circuit 331 in FIG. 6 or FIG.13) disposed on one surface of the flexible printed circuit board and configured to drive the display panel, and a shield film (e.g., the shield film 304 in FIGS. 6 to 9, FIG. 10, and FIGS. 11 to 21) attached to the flexible printed circuit board in a state of enclosing at least a portion of the DDI. In an embodiment, the flexible printed circuit board may include at least one through hole (e.g., the through hole 331a or the slit 331b in FIGS. 13 to 21) or at least one recess (e.g., the recess 331c in FIG. 19 or FIG. 20) provided in an area where the shield film is attached (hereinafter, an "attachment area").

According to an embodiment, the above-described display may further include a second recess (e.g., the recess 311a in FIG. 14 or the slit 319b or 311b in FIG. 15 or FIG. 21) disposed on the rear surface of the display panel. In an embodiment, the second recess may extend from a position corresponding to the at least one through hole and may be disposed across an edge of the attachment area or to be exposed at the edge of the attachment area.

According to an embodiment, the above-described display may further include a protective sheet (e.g., the protective sheet 311 of FIGS. 13 to 21) attached to the rear surface of the display panel. In an embodiment, at least a portion of the second recess may be surrounded by the protective sheet.

According to an embodiment, the above-described display may further include an adhesive layer (e.g., the adhesive layer 319 in FIGS. 13 to 21) disposed on the rear surface of the display panel to attach the flexible printed circuit board to the rear surface of the display panel. In an embodiment, at least a portion of the second recess may be surrounded by the adhesive layer.

According to an embodiment, the flexible printed circuit board may include the at least one through hole, and the at least one recess (e.g., the recess 331c in FIGS. 19 and 20) extending from the at least one through hole across an edge of the attachment area on the other surface of the flexible printed circuit board.

According to an embodiment, the flexible printed circuit board may include the at least one recess (e.g., a recess replacing the slit 331b in FIGS. 17 and 18) extending from inside of the attachment area on the one surface of the flexible printed circuit board across an edge of the attachment area.

According to an embodiment, the flexible printed circuit board may further include a slit (e.g., the slit 331b in FIGS. 17 and 18) extending from the at least one through hole across the edge of the attachment area.

According to an embodiment, the slit is provided to extend through both surfaces of the flexible printed circuit board.

According to an embodiment, the shield film may include an insulating layer (e.g., the insulating layer 343 in FIG. 8 or FIG. 9) disposed to enclose at least a portion of the DDI, and a shield layer (e.g., the shield layer 341 in FIGS. 7 to 9) disposed to correspond to at least a portion of the DDI with the insulating layer interposed therebetween. In an embodiment, the shield layer may be electrically connected to the flexible printed circuit board.

According to an embodiment, the shield layer may be electrically connected to a ground conductor of the flexible printed circuit board.

According to an embodiment of the disclosure, an electronic device (e.g., the electronic device 1001, 1002, 1004, 100, or 200 in FIGS. 1 to 5) may include the above-described display.

According to an embodiment, an electronic device (e.g., the electronic device 1001, 1002, 1004, 100, or 200 in FIGS. 1 to 5) may include a housing (e.g., the housing 201 in FIG. 4 and/or FIG. 5) including a first surface (e.g., the first surface110A in FIG. 2), a second surface (e.g., the second surface110B in FIG. 3) facing a direction opposite to the first surface, and a side structure (e.g., the side structure 210 in FIG. 3, FIG. 4 and/or FIG. 12) at least partially surrounding a space between the first surface and the second surface, a display (e.g., the display 1060 in FIG. 1 or the display 101, 230, or 300 in FIG. 2, FIGS. 4 to 6, FIG. 10, FIG. 11, and FIGS. 13 to 21) disposed in the space at least partially surrounded by the side structure and configured to output a screen through at least a portion of the first surface, and a processor (e.g., the processor 1020 in FIG. 1) or a communication module (e.g., the communication module 1090 in FIG. 1) configured to execute wireless communication by using at least a portion of the side structure (hereinafter, "radiation conductor") (e.g., the first radiation 210a or the second radiation conductor 210b in FIG. 12). In an embodiment, the display may include a display panel (e.g., the display 301 of FIG. 6, FIG. 10, FIG. 11, and FIGS. 13 to 21) including a light-emitting layer, a flexible printed circuit board (e.g., the flexible printed circuit board 303 in FIG. 6, FIG. 10, FIG. 11, and FIGS. 13 to 21) extending from the display panel at a position adjacent to the radiation conductor and at least partially disposed on a rear surface of the display panel, a DDI (e.g., the DDI 331 in FIG. 6 or FIG.13) disposed on one surface of the flexible printed circuit board and configured to drive the display panel, and a shield film (e.g., the shield film 304 in FIGS. 6 to 9, FIG. 10, and FIGS. 11 to 21) attached to the flexible printed circuit board in a state of enclosing at least a portion of the DDI. In an embodiment, the flexible printed circuit board may include at least one through hole (e.g., the through hole 331a or the slit 331b in FIGS. 13 to 21) or at least one recess (e.g., the recess 331c in FIG. 19 or FIG. 20) provided in an area where the shield film is attached (hereinafter, an "attachment area").

According to an embodiment, the side structure may include the radiation conductor disposed adjacent to the flexible printed circuit board or the DDI and extending to be at least partially parallel to the display panel, and an insulating member (e.g., the insulating material portion or synthetic resin material portion indicated by "211a" in FIG. 12) provided to enclose at least a portion of the radiation conductor.

According to an embodiment, the electronic device may further include a support member (e.g., the first support member 211 in FIG. 4, FIG. 5, or FIG. 12) disposed between the first surface and the second surface. In an embodiment, the flexible printed circuit board may be at least partially disposed between the display panel and the support member.

According to an embodiment, the display may further include a second recess (e.g., the recess 311a in FIG. 14 or the slit 319b or 311b in FIG. 15 or FIG. 21) disposed in the rear surface of the display panel. In an embodiment, the second recess may extend from a position corresponding to the at least one through hole and may be disposed across an edge of the attachment area or to be exposed at the edge of the attachment area.

According to an embodiment, the display may further include a protective sheet (e.g., the protective sheet 311 in FIGS. 13 to 21) attached to the rear surface of the display panel. In an embodiment, at least a portion of the second recess may be surrounded by the protective sheet.

According to an embodiment, the display may further include an adhesive layer (e.g., the adhesive layer 319 in FIGS. 13 to 21) disposed on the rear surface of the display panel to attach the flexible printed circuit board to the rear surface of the display panel. In an embodiment, at least a portion of the second recess may be surrounded by the adhesive layer.

According to an embodiment, the shield film may include an insulating layer (e.g., the insulating layer 343 in FIG. 8 or FIG. 9) disposed to enclose at least a portion of the DDI, and a shield layer (e.g., the shield layer 341 in FIGS. 7 to 9) disposed to correspond to at least a portion of the DDI with the insulating layer interposed therebetween. In an embodiment, the shield layer may be electrically connected to the flexible printed circuit board.

According to an embodiment, the shield layer may be electrically connected to a ground conductor of the flexible printed circuit board.

According to an embodiment, the shield layer may be configured to provide an electromagnetic shield structure between the DDI and the radiation conductor.

Although the disclosure has been described with reference to an embodiment as an example, it is to be understood that the embodiment is intended to be exemplary and is not limiting the disclosure. It will be apparent to those skilled in the art that various changes can be made in form and detail without departing from the overall scope of the disclosure, including the appended claims. For example, recesses or slits illustrated in different drawings may be replaced or be combined with each other, and the recesses or slits provided on an adhesive layer (or a protective sheet) may be variously combined depending on the number and positions of through holes provided in a flexible printed circuit board.

## Claims

1. A display (1060; 101; 230; 300) comprising:
a display panel (231; 301) comprising a light-emitting layer;
a flexible printed circuit board (233; 303) extending from the display panel (231; 301) and at least partially disposed on a rear surface of the display panel (231; 301);
a display driver integrated circuit, DDI, (331) disposed on one surface of the flexible printed circuit board (233; 303) and configured to drive the display panel (231; 301); and
a shield film (304) attached to the flexible printed circuit board (233; 303) in a state of enclosing at least a portion of the DDI (331),
wherein the flexible printed circuit board (233; 303) comprises at least one through hole (331a; 331b) or at least one recess (331c) provided in an attachment area where the shield film (304) is attached,
**characterised in that**
the at least one through hole (331a; 331b) or the at least one recess (331c) is configured to function as air discharge passage when the shield film (304) is attached to the flexible printed circuit board (233; 303).

2. The display (1060; 101; 230; 300) of claim 1, further comprising a second recess (311a; 319b; 311b) disposed on a rear surface of the display panel (231; 301),
wherein the second recess (311a; 319b; 311b) extends from a position corresponding to the at least one through hole (319a; 331a) and is disposed across an edge of the attachment area or to be exposed at the edge of the attachment area.

3. The display (1060; 101; 230; 300) of claim 2, further comprising a protective sheet (311) attached to the rear surface of the display panel (231; 301),
wherein at least a portion of the second recess (311a; 319b; 311b) is surrounded by the protective sheet (311).

4. The display (1060; 101; 230; 300) of one of claims 2 to 3, further comprising an adhesive layer (319) disposed on the rear surface of the display panel (231; 301) to attach the flexible printed circuit board (233; 303) to the rear surface of the display panel (231; 301),
wherein at least a portion of the second recess (311a; 319b; 311b) is surrounded by the adhesive layer (319).

5. The display (1060; 101; 230; 300) of one of the preceding claims, wherein the flexible printed circuit board (233; 303) comprises:
the at least one through hole (331a); and
the at least one recess (331c) extending from the at least one through hole (331a) across an edge of the attachment area on another surface of the flexible printed circuit board (233; 303).

6. The display (1060; 101; 230; 300) of one of the preceding claims, wherein the flexible printed circuit board (233; 303) comprises the at least one recess (331c) extending from inside of the attachment area on the one surface of the flexible printed circuit board (233; 303) across an edge of the attachment area.

7. The display (1060; 101; 230; 300) of one of the preceding claims, wherein the flexible printed circuit board (233; 303) further comprises a slit (331b) extending from the at least one through hole across the edge of the attachment area.

8. The display (1060; 101; 230; 300) of claim 7, wherein the slit (319b) is provided to extend through both surfaces of the flexible printed circuit board (233; 303).

9. The display (1060; 101; 230; 300) of one of the preceding claims, wherein the shield film comprises:
an insulating layer (343) disposed to enclose at least a portion of the DDI; and
a shield layer (341) disposed to correspond to at least a portion of the DDI with the insulating layer (343) interposed therebetween, and
wherein the shield layer (341) is electrically connected to the flexible printed circuit board (233; 303).

10. The display (1060; 101; 230; 300) of claim 9, wherein the shield layer (341) is electrically connected to a ground conductor of the flexible printed circuit board (233; 303).

11. An electronic device (1001; 1002; 1004; 100; 200) comprising a display (1060; 101; 230; 300) according to one of the preceding claims.

12. The electronic device (1001; 1002; 1004; 100; 200) of claim 11, further comprising:
a housing (110; 201) comprising a first surface (110A), a second surface (110B) facing a direction opposite to the first surface (110A), and a side structure (118; 210) at least partially surrounding a space between the first surface (110A) and the second surface (110B);
wherein the display (1060; 101; 230; 300) is disposed in the space at least partially surrounded by the side structure (118; 210) and configured to output a screen through at least a portion of the first surface (110A); and
a processor (1020) or a communication module (1090) configured to execute wireless communication by using a radiation conductor (210a, 210b) formed by at least a portion of the side structure (118; 210),
wherein the flexible printed circuit board (233; 303) extends from the display panel (231; 301) at a position adjacent to the radiation conductor (210a, 210b).

13. The electronic device (100; 200; 1001; 1002; 1004) of claim 12, wherein the side structure (118; 210) comprises:
the radiation conductor (210a, 201b) disposed adjacent to the flexible printed circuit board (233; 303) or the DDI and extending to be at least partially parallel to the display panel (231; 301); and
an insulating member (211a) provided to enclose at least a portion of the radiation conductor (210a, 210b).

14. The electronic device (100; 200; 1001; 1002; 1004) of one of claims 12 and 13, further comprising a support member (211) disposed between the first surface (110A) and the second surface (110B),
wherein the flexible printed circuit board (233; 303) is at least partially disposed between the display panel (231; 301) and the support member (211).

15. The electronic device (100; 200; 1001; 1002; 1004) of one of claims 11 to 14, wherein the shield layer (341) is configured to provide an electromagnetic shield structure between the DDI and the radiation conductor (210a, 210b).

## Patentansprüche

1. Anzeige (1060; 101; 230; 300), umfassend:
eine Anzeigetafel (231; 301), die eine lichtemittierende Schicht umfasst;
eine flexible Leiterplatte (233; 303), die sich von der Anzeigetafel (231; 301) erstreckt und zumindest teilweise auf einer hinteren Fläche der Anzeigetafel (231; 301) angeordnet ist;
eine integrierte Anzeigetreiberschaltung, DDI, (331), die auf einer Fläche der flexiblen Leiterplatte (233; 303) angeordnet und konfiguriert ist, um die Anzeigetafel (231; 301) anzutreiben; und
einen Abschirmfilm (304), der an der flexiblen Leiterplatte (233; 303) in einem Zustand befestigt ist, in dem zumindest ein Abschnitt der DDI (331) umschlossen ist,
wobei die flexible Leiterplatte (233; 303) mindestens ein Durchgangsloch (331a; 331b) oder mindestens eine Aussparung (331c) umfasst, das/die in einem Befestigungsbereich bereitgestellt ist, in dem der Abschirmfilm (304) befestigt ist, und
**dadurch gekennzeichnet, dass** das mindestens eine Durchgangsloch (331a; 331b) oder die mindestens eine Aussparung (331c) konfiguriert ist, um als Luftablasskanal zu fungieren, wenn der Abschirmfilm (304) an der flexiblen Leiterplatte (233; 303) befestigt ist.

2. Anzeige (1060; 101; 230; 300) nach Anspruch 1, ferner umfassend eine zweite Aussparung (311a; 319b; 311b), die auf einer hinteren Fläche der Anzeigetafel (231; 301) angeordnet ist,
wobei sich die zweite Aussparung (311a; 319b; 311b) von einer Position erstreckt, die dem mindestens einen Durchgangsloch (319a; 331a) entspricht, und über eine Kante des Befestigungsbereichs angeordnet ist oder an der Kante des Befestigungsbereichs freiliegen soll.

3. Anzeige (1060; 101; 230; 300) nach Anspruch 2, ferner umfassend eine Schutzfolie (311), die an der hinteren Fläche der Anzeigetafel (231; 301) befestigt ist,
wobei zumindest ein Abschnitt der zweiten Aussparung (311a; 319b; 311b) von der Schutzfolie (311) umgeben ist.

4. Anzeige (1060; 101; 230; 300) nach einem der Ansprüche 2 bis 3, ferner umfassend eine Haftschicht (319), die auf der hinteren Fläche der Anzeigetafel (231; 301) angeordnet ist, um die flexible Leiterplatte (233; 303) an der hinteren Fläche der Anzeigetafel (231; 301) zu befestigen,
wobei zumindest ein Abschnitt der zweiten Aussparung (311a; 319b; 311b) von der Haftschicht (319) umgeben ist.

5. Anzeige (1060; 101; 230; 300) nach einem der vorhergehenden Ansprüche, wobei die flexible Leiterplatte (233; 303) Folgendes umfasst:
das mindestens eine Durchgangsloch (331a); und
die mindestens eine Aussparung (331c), die sich von dem mindestens einen Durchgangsloch (331a) über eine Kante des Befestigungsbereichs auf einer anderen Fläche der flexiblen Leiterplatte (233; 303) erstreckt.

6. Anzeige (1060; 101; 230; 300) nach einem der vorhergehenden Ansprüche, wobei die flexible Leiterplatte (233; 303) die mindestens eine Aussparung (331c) umfasst, die sich von einer Innenseite des Befestigungsbereichs auf der einen Fläche der flexiblen Leiterplatte (233; 303) über eine Kante des Befestigungsbereichs erstreckt.

7. Anzeige (1060; 101; 230; 300) nach einem der vorhergehenden Ansprüche, wobei die flexible Leiterplatte (233; 303) ferner einen Schlitz (331b) umfasst, der sich von dem mindestens einen Durchgangsloch über die Kante des Befestigungsbereichs erstreckt.

8. Anzeige (1060; 101; 230; 300) nach Anspruch 7, wobei der Schlitz (319b) so bereitgestellt ist, dass er sich durch beide Flächen der flexiblen Leiterplatte (233; 303) erstreckt.

9. Anzeige (1060; 101; 230; 300) nach einem der vorhergehenden Ansprüche, wobei der Abschirmfilm Folgendes umfasst:
eine Isolationsschicht (343), die so angeordnet ist, dass sie mindestens einen Abschnitt der DDI umschließt; und
eine Abschirmschicht (341), die so angeordnet ist, dass sie mindestens einem Abschnitt der DDI entspricht, wobei die Isolationsschicht (343) dazwischen angeordnet ist, und
wobei die Abschirmschicht (341) elektrisch mit der flexiblen Leiterplatte (233; 303) verbunden ist.

10. Anzeige (1060; 101; 230; 300) nach Anspruch 9, wobei die Abschirmschicht (341) elektrisch mit einem Erdungsleiter der flexiblen Leiterplatte (233; 303) verbunden ist.

11. Elektronische Vorrichtung (1001; 1002; 1004; 100; 200), umfassend eine Anzeige (1060; 101; 230; 300) nach einem der vorhergehenden Ansprüche.

12. Elektronische Vorrichtung (1001; 1002; 1004; 100; 200) nach Anspruch 11, ferner umfassend:
ein Gehäuse (110; 201), das eine erste Fläche (110A), eine zweite Fläche (110B), die in eine der ersten Fläche (110A) entgegengesetzte Richtung weist, und eine Seitenstruktur (118; 210) umfasst, die einen Raum zwischen der ersten Fläche (110A) und der zweiten Fläche (110B) zumindest teilweise umgibt;
wobei die Anzeige (1060; 101; 230; 300) in dem Raum angeordnet ist, der zumindest teilweise von der Seitenstruktur (118; 210) umgeben ist, und konfiguriert ist, um einen Bildschirm durch zumindest einen Abschnitt der ersten Fläche (110A) auszugeben; und
einen Prozessor (1020) oder ein Kommunikationsmodul (1090), der/das zum Ausführen einer drahtlosen Kommunikation unter Verwendung eines Strahlungsleiters (210a, 210b) konfiguriert ist, der durch mindestens einen Abschnitt der Seitenstruktur (118; 210) ausgebildet ist,
wobei sich die flexible Leiterplatte (233; 303) von der Anzeigetafel (231; 301) an einer Position angrenzend an den Strahlungsleiter (210a, 210b) erstreckt.

13. Elektronische Vorrichtung (100; 200; 1001; 1002; 1004) nach Anspruch 12, wobei die Seitenstruktur (118; 210) Folgendes umfasst:
den Strahlungsleiter (210a, 201b), der angrenzend an die flexible Leiterplatte (233; 303) oder die DDI angeordnet ist und sich so erstreckt, dass er zumindest teilweise parallel zu der Anzeigetafel (231; 301) verläuft; und
ein Isolationselement (211a), das bereitgestellt ist, um zumindest einen Abschnitt des Strahlungsleiters (210a, 210b) zu umschließen.

14. Elektronische Vorrichtung (100; 200; 1001; 1002; 1004) nach einem der Ansprüche 12 und 13, ferner umfassend ein Stützelement (211), das zwischen der ersten Fläche (110A) und der zweiten Fläche (110B) angeordnet ist,
wobei die flexible Leiterplatte (233; 303) zumindest teilweise zwischen der Anzeigetafel (231; 301) und dem Stützelement (211) angeordnet ist.

15. Elektronische Vorrichtung (100; 200; 1001; 1002; 1004) nach einem der Ansprüche 11 bis 14, wobei die Abschirmschicht (341) konfiguriert ist, um eine elektromagnetische Abschirmstruktur zwischen der DDI und dem Strahlungsleiter (210a, 210b) bereitzustellen.

## Revendications

1. Affichage (1060 ; 101 ; 230 ; 300) comprenant :
un panneau d'affichage (231 ; 301) comprenant une couche électroluminescente ;
un circuit imprimé flexible (233 ; 303) s'étendant à partir du panneau d'affichage (231 ; 301) et au moins partiellement disposé sur une surface arrière du panneau d'affichage (231 ; 301) ;
un circuit intégré de commande d'affichage, DDI, (331) disposé sur une surface de la carte de circuit imprimé flexible (233 ; 303) et configuré pour commander le panneau d'affichage (231 ; 301) ; et
un film de blindage (304) fixé à la carte de circuit imprimé flexible (233 ; 303) dans un état d'enfermement d'au moins une partie du DDI (331),
dans lequel la carte de circuit imprimé flexible (233 ; 303) comprend au moins un trou traversant (331a ; 331b) ou au moins un évidement (331c) prévu dans une zone de fixation où le film de blindage (304) est fixé, et
**caractérisé en ce que** l'au moins un trou traversant (331a ; 331b) ou l'au moins un évidement (331c) est configuré pour fonctionner comme passage d'évacuation d'air lorsque le film de blindage (304) est fixé à la carte de circuit imprimé flexible (233 ; 303).

2. Affichage (1060 ; 101 ; 230 ; 300) de la revendication 1, comprenant en outre un deuxième évidement (311a ; 319b ; 311b) disposé sur une surface arrière du panneau d'affichage (231 ; 301),
dans lequel le deuxième évidement (311a ; 319b ; 311b) s'étend à partir d'une position correspondant à l'au moins un trou traversant (319a ; 331a) et est disposé en travers d'un bord de la zone de fixation ou pour être exposé au bord de la zone de fixation.

3. Affichage (1060 ; 101 ; 230 ; 300) de la revendication 2, comprenant en outre une feuille de protection (311) fixée à la surface arrière du panneau d'affichage (231 ; 301),
dans lequel au moins une partie du deuxième évidement (311a ; 319b ; 311b) est entourée par la feuille de protection (311).

4. Affichage (1060 ; 101 ; 230 ; 300) de l'une des revendications 2 à 3, comprenant en outre une couche adhésive (319) disposée sur la surface arrière du panneau d'affichage (231 ; 301) pour fixer la carte de circuit imprimé flexible (233 ; 303) à la surface arrière du panneau d'affichage (231 ; 301),
dans lequel au moins une partie du deuxième évidement (311a ; 319b ; 311b) est entourée par la couche adhésive (319).

5. Affichage (1060 ; 101 ; 230 ; 300) de l'une des revendications précédentes, dans lequel la carte de circuit imprimé flexible (233 ; 303) comprend :
l'au moins un trou traversant (331a) ; et
l'au moins un évidement (331c) s'étendant à partir de l'au moins un trou traversant (331a) à travers un bord de la zone de fixation sur une autre surface de la carte de circuit imprimé flexible (233 ; 303).

6. Affichage (1060 ; 101 ; 230 ; 300) de l'une des revendications précédentes, dans lequel la carte de circuit imprimé flexible (233 ; 303) comprend l'au moins un évidement (331c) s'étendant de l'intérieur de la zone de fixation sur l'une surface de la carte de circuit imprimé flexible (233 ; 303) à travers un bord de la zone de fixation.

7. Affichage (1060 ; 101 ; 230 ; 300) de l'une des revendications précédentes, dans lequel la carte de circuit imprimé flexible (233 ; 303) comprend en outre une fente (331b) s'étendant depuis l'au moins un trou traversant à travers le bord de la zone de fixation.

8. Affichage (1060 ; 101 ; 230 ; 300) de la revendication 7, dans lequel la fente (319b) est prévue pour s'étendre à travers les deux surfaces de la carte de circuit imprimé flexible (233 ; 303).

9. Affichage (1060 ; 101 ; 230 ; 300) de l'une des revendications précédentes, dans lequel le film de blindage comprend :
une couche isolante (343) disposée de manière à entourer au moins une partie du DDI ; et
une couche de blindage (341) disposée de manière à correspondre à au moins une partie du DDI, la couche isolante (343) étant interposée entre ceux-ci, et
dans lequel la couche de blindage (341) est connectée électriquement à la carte de circuit imprimé flexible (233 ; 303).

10. Affichage (1060 ; 101 ; 230 ; 300) de la revendication 9, dans lequel la couche de blindage (341) est électriquement connectée à un conducteur de masse de la carte de circuit imprimé flexible (233 ; 303).

11. Dispositif électronique (1001 ; 1002 ; 1004 ; 100 ; 200) comprenant un affichage (1060 ; 101 ; 230 ; 300) selon l'une des revendications précédentes.

12. Dispositif électronique (1001, 1002, 1004, 100, 200) de la revendication 11, comprenant en outre :
un boîtier (110 ; 201) comprenant une première surface (110A), une deuxième surface (110B) orientée dans une direction opposée à la première surface (110A), et une structure latérale (118 ; 210) entourant au moins partiellement un espace entre la première surface (110A) et la deuxième surface (110B) ;
dans lequel l'affichage (1060 ; 101 ; 230 ; 300) est disposé dans l'espace au moins partiellement entouré par la structure latérale (118 ; 210) et configuré pour produire un écran à travers au moins une partie de la première surface (110A) ; et
un processeur (1020) ou un module de communication (1090) configuré pour exécuter une communication sans fil en utilisant un conducteur de rayonnement (210a, 210b) formé par au moins une partie de la structure latérale (118 ; 210),
dans lequel la carte de circuit imprimé flexible (233 ; 303) s'étend à partir du panneau d'affichage (231 ; 301) à une position adjacente au conducteur de rayonnement (210a, 210b).

13. Dispositif électronique (100 ; 200 ; 1001 ; 1002 ; 1004) de la revendication 12, dans lequel la structure latérale (118 ; 210) comprend :
le conducteur de rayonnement (210a, 201b) disposé de manière adjacente à la carte de circuit imprimé flexible (233 ; 303) ou du DDI et s'étendant pour être au moins partiellement parallèle au panneau d'affichage (231 ; 301) ; et
un élément isolant (211a) prévu pour entourer au moins une partie du conducteur de rayonnement (210a, 210b).

14. Dispositif électronique (100 ; 200 ; 1001 ; 1002 ; 1004) de l'une des revendications 12 et 13, comprenant en outre un élément de support (211) disposé entre la première surface (110A) et la deuxième surface (110B),
dans lequel la carte de circuit imprimé flexible (233 ; 303) est au moins partiellement disposée entre le panneau d'affichage (231 ; 301) et l'élément de support (211).

15. Dispositif électronique (100 ; 200 ; 1001 ; 1002 ; 1004) de l'une des revendications 11 à 14, dans lequel la couche de blindage (341) est configurée pour fournir une structure de blindage électromagnétique entre le DDI et le conducteur de rayonnement (210a, 210b).
